# EUROPEAN PATENT APPLICATION

(11) **EP 4 498 764 A1**
(43) Date of publication of application: **29.01.2025**
(21) Application number: 23830245.9
(22) Date of filing: 27.06.2023
(51) Int. Cl.: H05K 1/11, H05K 3/00

(54) **FLEXIBLE CIRCUIT BOARD, CIRCUIT BOARD ASSEMBLY, AND ELECTRONIC DEVICE**

(30) Priority: 30.06.2022 CN 202210758071
(71) Applicant: Huawei Technologies Co., Ltd., Shenzhen, Guangdong 518129 (CN)
(72) Inventor: ZHANG, Tong, Shenzhen, Guangdong 518129 (CN); JIANG, Fan, Shenzhen, Guangdong 518129 (CN); WEI, Dan, Shenzhen, Guangdong 518129 (CN); SHI, Lin, Shenzhen, Guangdong 518129 (CN)
(74) Representative: Pfenning, Meinig & Partner mbB
(86) International application number: PCT/CN2023/102737
(87) International publication number: WO 2024/002068

(57) **Abstract**

This application discloses a flexible printed circuit, a circuit board assembly, and an electronic device. The flexible printed circuit includes a bending portion and a soldering portion connected to the bending portion. The flexible printed circuit includes a plurality of conductive layers and a plurality of insulation layers, and the insulation layer is disposed between two adjacent conductive layers. The plurality of conductive layers include a first soldering layer, a second soldering layer, and a trace layer. Both the first soldering layer and the second soldering layer are located in the soldering portion. The first soldering layer is one surface layer of the soldering portion, and the first soldering layer is formed by a plurality of first pads that are spaced from each other. The second soldering layer is the other surface layer of the soldering portion, and the second soldering layer is formed by a plurality of second pads that are spaced from each other. The trace layer is located between the first soldering layer and the second soldering layer, and extends from the soldering portion to the bending portion. The first pad and the second pad are connected by using a through hole conductor, and are connected to the trace layer. A pad spacing in the soldering portion of the flexible printed circuit is relatively small, so that a surface area of the soldering portion can be reduced, facilitating miniaturization.

## Description

This application claims priority to Chinese Patent Application No. 202210758071.2, filed with the China National Intellectual Property Administration on June 30, 2022 and entitled "FLEXIBLE PRINTED CIRCUIT, CIRCUIT BOARD ASSEMBLY, AND ELECTRONIC DEVICE", which is incorporated herein by reference in its entirety.

### TECHNICAL FIELD

This application relates to the field of circuit connection structure technologies, and in particular, to a flexible printed circuit, a circuit board assembly, and an electronic device.

### BACKGROUND

Currently, with continuous development of electronic devices such as mobile phones, printed circuit boards (printed circuit boards, PCBs, also referred to as printed circuit boards) and flexible printed circuits (flexible printed circuits, FPCs) are widely applied in the electronic devices. The flexible printed circuit and the printed circuit board may be soldered together by using a flexible printed circuit on board (FPC on board, FOB) technology, to implement signal and/or power transmission.

However, a conventional flexible printed circuit has a large pad spacing, which requires large soldering space to be reserved on both the flexible printed circuit and the printed circuit board. As a result, a size of a circuit board assembly is large, making it difficult to implement miniaturization and multifunctionality of the electronic devices.

### SUMMARY

This application provides a flexible printed circuit. A pad spacing in a soldering portion of the flexible printed circuit is relatively small, so that a surface area of the soldering portion can be reduced, facilitating miniaturization. This application further provides a circuit board assembly including the foregoing flexible printed circuit, and an electronic device including the foregoing circuit board assembly.

According to a first aspect, this application provides a flexible printed circuit, including a bending portion and a soldering portion connected to the bending portion. The flexible printed circuit includes a plurality of conductive layers and a plurality of insulation layers, and the insulation layer is disposed between two adjacent conductive layers. The plurality of conductive layers include a first soldering layer, a second soldering layer, and a trace layer. Both the first soldering layer and the second soldering layer are located in the soldering portion. The first soldering layer is one surface layer of the soldering portion, and the first soldering layer is formed by a plurality of first pads that are spaced from each other. The second soldering layer is the other surface layer of the soldering portion, and the second soldering layer is formed by a plurality of second pads that are spaced from each other. The trace layer is located between the first soldering layer and the second soldering layer, and extends from the soldering portion to the bending portion. The first pad and the second pad are connected by using a through hole conductor, and the through hole conductor is connected to the trace layer.

In this application, the first soldering layer and the second soldering layer are used as two surface layers of the soldering portion, only the first pad is arranged and no trace is arranged on the first soldering layer, only the second pad is arranged and no trace is arranged on the second soldering layer. Therefore, the soldering portion does not need to arrange a protective layer (or referred to as a solder mask layer) outside the first soldering layer and the second soldering layer, and no solder mask opening structure needs to be disposed. This can implement a solder mask-free design, and the pad spacing in the soldering portion (that is, a spacing between two adjacent first pads and a spacing between two adjacent second pads) is not limited by structures such as a trace and a solder mask opening. Compared with a pad spacing in a conventional technology, the pad spacing is obviously reduced, so that a surface area of the soldering portion can be reduced, facilitating miniaturization of the flexible printed circuit. In addition, the trace of the flexible printed circuit is arranged on the trace layer, is an inner layer structure of the flexible printed circuit, and is covered by the insulation layer or the protective layer. This helps improve circuit reliability of the flexible printed circuit.

In addition, compared with a conventional product, the flexible printed circuit in this application separately disposes a plurality of pads on the soldering layer. The soldering layer may increase a quantity of conductive layers. However, because a thickness of the conductive layer is very small, for example, a thickness of a current copper foil layer is usually 0.25 micrometer, an increase in an overall thickness of the flexible printed circuit in this application is small and controllable, and does not cause obvious adverse impact or an obvious obstacle to miniaturization of both a circuit board assembly and an electronic device that use the flexible printed circuit.

The through hole conductor may be a conductive layer structure formed on a through hole wall, or a conductor pillar structure filled in a through hole.

In a possible implementation, the trace layer includes a conductor block and a trace. The conductor block is located in the soldering portion. One end of the trace is connected to the conductor block, and the other end of the trace extends to the bending portion. The pad is connected to the conductor block by using the through hole conductor. The first pad and the second pad are connected to the conductor block by using the through hole conductor. The first pad and the second pad may be electrically connected to another part or another component of the flexible printed circuit by using the conductor block and the trace.

In a possible implementation, a shape of the conductor block may be the same as or similar to a shape of the first pad.

In a possible implementation, an area of the conductor block is the same as an area of the first pad. Compared with the pad spacing in a conventional solution, the pad spacing in this application may be reduced by about 22%. In a structure in which the plurality of pads are arranged in an array, the surface area of the soldering portion of the flexible printed circuit in this application may be about 40% less than a surface area of a soldering portion of a conventional product. The surface area of the soldering portion is greatly reduced, which facilitates miniaturization of the flexible printed circuit and miniaturization of both the circuit board assembly and the electronic device that use the flexible printed circuit.

In a possible implementation, an area of the conductor block is less than an area of the first pad. In this implementation, because the first pad and the second pad are connected to the conductor block by using the through hole conductor, locations of the first pad and the second pad are limited by a disposition of the conductor block. The area of the conductor block is less than the area of the first pad, so that the area of the conductor block may be set to a small value when an internal connection requirement (that is, the conductor block is connected to the through hole conductor) is met. In this way, when the trace layer meets a trace arrangement requirement, a spacing between two adjacent conductor blocks may be relatively small. Then, a center spacing between two adjacent first pads is relatively small. This can further reduce the pad spacing in the soldering portion, facilitating miniaturization of the flexible printed circuit.

In a possible implementation, there are a plurality of trace layers, and the plurality of conductor blocks connected to the plurality of first pads are located at different trace layers. Conductor blocks that are correspondingly connected to at least two first pads in the plurality of first pads may be located on different trace layers.

The trace layer arranged with the conductor block further needs to arrange the trace connected to the conductor block. Therefore, when the plurality of conductor blocks connected to the plurality of first pads are centrally arranged on a specific trace layer of the flexible printed circuit, the trace layer has a relatively high trace arrangement requirement. As a result, space of the trace layer is insufficient, and trace arrangement is difficult. When the conductor blocks correspondingly connected to the at least two first pads in the plurality of first pads are located on the different trace layers, traces connected to the conductor blocks may also be distributed on the different trace layers. This reduces routing difficulty of the trace layers and improves routing flexibility.

In a possible implementation, there are one or more trace layers, and a plurality of punctured regions are provided at each trace layer. A plurality of through hole conductors pass through the plurality of punctured regions of each trace layer in a one-to-one correspondence. Support blocks are disposed in the plurality of punctured regions of each trace layer. The through hole conductor passes through the support block and is connected to the support block. When there is one trace layer, the support block is the conductor block. Alternatively, when there are a plurality of trace layers, the support block is the conductor block or a bottom pad.

In this implementation, because the support block (the conductor block or the bottom pad) is disposed in the punctured region of each trace layer of the flexible printed circuit, an overall support structure of each punctured region of the flexible printed circuit is stable and collapse is unlikely to occur. In addition, thicknesses of the plurality of punctured regions of the flexible printed circuit can be consistent. This facilitates batch punching and metal filling, and improves production efficiency and a yield of the flexible printed circuit.

In a possible implementation, the plurality of insulation layers includes a first insulation layer and a second insulation layer. The first insulation layer is located between the first soldering layer and the adjacent trace layer, and extends from the soldering portion to the bending portion, and a part of the first insulation layer located in the bending portion forms one surface layer of the bending portion. The second insulation layer is located between the second soldering layer and the adjacent trace layer, and extends from the soldering portion to the bending portion, and a part of the second insulation layer located in the bending portion forms the other surface layer of the bending portion.

In a possible implementation, the plurality of conductive layers further include a first routing layer and a second routing layer. Both the first routing layer and the second routing layer are located in the bending portion. The first routing layer and the first soldering layer are disposed on a same layer, and the second routing layer and the second soldering layer are disposed on a same layer. The flexible printed circuit further includes a first protective layer and a second protective layer. Both the first protective layer and the second protective layer are located in the bending portion. The first protective layer is located on a side that is of the first routing layer and that is away from the trace layer. The second protective layer is located on a side that is of the second routing layer and that is away from the trace layer. The first protective layer and the second protective layer are two surface layers of the bending portion.

In this implementation, the first routing layer and the second routing layer are disposed in the bending portion of the flexible printed circuit. The first routing layer, the second routing layer, and the trace layer may all be configured for trace arrangement. Therefore, the flexible printed circuit can better meet a routing requirement such as a plurality of transmission channels.

In a possible implementation, at least one insulation layer of the flexible printed circuit forms an air gap in the bending portion. In this way, structures of the flexible printed circuit located on two sides of the air gap may move relatively independently, to improve bending performance of the bending portion of the flexible printed circuit.

According to a second aspect, this application further provides a flexible printed circuit, including a bending portion and a soldering portion connected to the bending portion. The flexible printed circuit includes a plurality of conductive layers, a plurality of insulation layers, and a first protective layer. The insulation layer is disposed between two adjacent conductive layers. The plurality of conductive layers include a soldering layer and a trace layer. The soldering layer is located in the soldering portion, the soldering layer is one surface layer of the soldering portion, and the soldering layer is formed by a plurality of pads that are spaced from each other. The trace layer is located on a side of the soldering layer and extends from the soldering portion to the bending portion. The pad is connected to the trace layer by using a through hole conductor. The first protective layer is located on a side that is of the trace layer and that is away from the soldering layer. The first protective layer extends from the soldering portion to the bending portion. A part of the first protective layer located in the soldering portion forms the other surface layer of the soldering portion. A part of the first protective layer located in the bending portion forms one surface layer of the bending portion.

In this implementation, the soldering layer is used as one surface layer of the soldering portion, and only the pad is arranged and no trace is arranged on the soldering layer. Therefore, the soldering portion does not need to arrange a protective layer (or referred to as a solder mask layer) outside the soldering layer, and no solder mask opening structure needs to be disposed. This can implement a solder mask-free design, and the pad spacing in the soldering portion is not limited by structures such as a trace and a solder mask opening. Compared with a pad spacing in a conventional technology, the pad spacing is obviously reduced, so that a surface area of the soldering portion can be reduced, facilitating miniaturization of the flexible printed circuit.

In addition, compared with a conventional product, the flexible printed circuit in this application separately disposes a plurality of pads on the soldering layer. The soldering layer may increase a quantity of conductive layers. However, because a thickness of the conductive layer is very small, an increase in an overall thickness of the flexible printed circuit in this application is small and controllable, and does not cause obvious adverse impact or an obvious obstacle to miniaturization of both a circuit board assembly and an electronic device that use the flexible printed circuit.

In a possible implementation, the trace layer includes a conductor block and a trace. The conductor block is located in the soldering portion. One end of the trace is connected to the conductor block, and the other end of the trace extends to the bending portion. The pad is connected to the conductor block by using the through hole conductor. The pad may be electrically connected to another part or another component of the flexible printed circuit by using the conductor block and the trace.

In a possible implementation, a shape of the conductor block may be the same as or similar to a shape of the pad.

In a possible implementation, an area of the conductor block is the same as an area of the pad. Compared with the pad spacing in a conventional solution, the pad spacing in this application may be reduced by about 22%. In a structure in which the plurality of pads are arranged in an array, the surface area of the soldering portion of the flexible printed circuit in this application may be about 40% less than a surface area of a soldering portion of a conventional product. The surface area of the soldering portion is greatly reduced, which facilitates miniaturization of the flexible printed circuit and miniaturization of both the circuit board assembly and the electronic device that use the flexible printed circuit.

In a possible implementation, an area of the conductor block is less than an area of the pad. In this implementation, because the pad and the second pad are connected to the conductor block by using the through hole conductor, locations of the pad and the second pad are limited by a disposition of the conductor block. The area of the conductor block is less than the area of the pad, so that the area of the conductor block may be set to a small value when an internal connection requirement (that is, the conductor block is connected to the through hole conductor) is met. In this way, when the trace layer meets a trace arrangement requirement, a spacing between two adjacent conductor blocks may be relatively small. Then, a center spacing between two adjacent pads is relatively small. This can further reduce the pad spacing in the soldering portion, facilitating miniaturization of the flexible printed circuit.

In a possible implementation, there are a plurality of trace layers, and the plurality of conductor blocks connected to the plurality of pads are located at different trace layers. Conductor blocks that are correspondingly connected to at least two pads in the plurality of pads may be located on different trace layers. The trace layer arranged with the conductor block further needs to arrange the trace connected to the conductor block. Therefore, when the plurality of conductor blocks connected to the plurality of pads are centrally arranged on a specific trace layer of the flexible printed circuit, the trace layer has a relatively high trace arrangement requirement. As a result, space of the trace layer is insufficient, and trace arrangement is difficult. When the conductor blocks correspondingly connected to the at least two pads in the plurality of pads are located on the different trace layers, traces connected to the conductor blocks may also be distributed on the different trace layers. This reduces routing difficulty of the trace layers and improves routing flexibility.

In a possible implementation, there are one or more trace layers, and a plurality of punctured regions are provided at each trace layer. A plurality of through hole conductors pass through the plurality of punctured regions of each trace layer in a one-to-one correspondence. Support blocks are disposed in the plurality of punctured regions of each trace layer. The through hole conductor passes through the support block and is connected to the support block. When there is one trace layer, the support block is the conductor block. Alternatively, when there are a plurality of trace layers, the support block is the conductor block or a bottom pad.

In this implementation, because a support block (a conductor block or a bottom pad) is disposed in a punctured region of each trace layer of the flexible printed circuit, an overall support structure of each punctured region of the flexible printed circuit is stable and collapse is unlikely to occur. In addition, thicknesses of the plurality of punctured regions of the flexible printed circuit can be consistent. This facilitates batch punching and metal filling, and improves production efficiency and a yield of the flexible printed circuit.

In a possible implementation, the plurality of insulation layers include a first insulation layer. The first insulation layer is located between the soldering layer and the adjacent trace layer, and extends from the soldering portion to the bending portion. A part of the first insulation layer located in the bending portion forms the other surface layer of the bending portion.

In a possible implementation, the plurality of conductive layers further include a routing layer, the routing layer is located in the bending portion, and the routing layer and the soldering layer are disposed on a same layer. The flexible printed circuit further includes a second protective layer. The second protective layer is located on a side that is of the routing layer and that is away from the trace layer. The second protective layer is located in the bending portion and is the other surface layer of the bending portion.

In a possible implementation, at least one insulation layer of the flexible printed circuit forms an air gap in the bending portion. In this way, structures of the flexible printed circuit located on two sides of the air gap may move relatively independently, to improve bending performance of the bending portion of the flexible printed circuit.

According to a third aspect, this application further provides a circuit board assembly, including a circuit board and the flexible printed circuit in any one of the foregoing descriptions. A soldering portion of the flexible printed circuit is soldered to the circuit board.

Because a pad of the soldering portion of the flexible printed circuit is a structure protruding from a surface, solder paste collapse and a short circuit can be avoided in a soldering process, and a soldering joint is ensured to have a specific height. This improves soldering quality and reliability.

In a possible implementation, the circuit board assembly includes a first circuit board, a second circuit board, the flexible printed circuit, a first component, and a second component. The flexible printed circuit includes two soldering portions and a bending portion connecting the two soldering portions. The two soldering portions of the flexible printed circuit are respectively soldered to the first circuit board and the second circuit board. A structure of each of the soldering portion and the bending portion of the flexible printed circuit may use any one of the foregoing structures. The first circuit board may be a printed circuit board or a flexible printed circuit, and the second circuit board may be a printed circuit board or a flexible printed circuit. There may be one or more first components, and the first component is fastened and electrically connected to the first circuit board. There may be one or more second components, and the second component is fastened and electrically connected to the second circuit board. The flexible printed circuit is configured to implement an electrical connection between the first component and the second component.

The first circuit board and the second circuit board may be stacked. The bending portion of the flexible printed circuit is bent, so that the circuit board assembly forms a sandwich stack structure. The entire circuit board assembly occupies relatively small space, and requires relatively small installation space. This helps reduce installation difficulty and improve an application scope. In some other implementations, the first circuit board and the second circuit board may alternatively form another relative position relationship, for example, a staggered arrangement.

In some implementations, the circuit board assembly includes a first circuit board, a second circuit board, the flexible printed circuit, a first electrical connector, a second electrical connector, a first component, and a second component. The flexible printed circuit includes the soldering portion, a connection portion, and a bending portion that connects the soldering portion and the connection portion. A structure of each of the soldering portion and the bending portion of the flexible printed circuit may use any one of the foregoing structures. The first circuit board may be a printed circuit board or a flexible printed circuit. There may be one or more first components, and the first component is fastened and electrically connected to the first circuit board. The soldering portion of the flexible printed circuit is soldered to the first circuit board. There may be one or more second components, and the second component is fastened and electrically connected to the second circuit board. The first electrical connector and the second electrical connector may be a male connector and a female connector respectively, and the male connector and the female connector are paired with each other. Each of the first electrical connector and the second electrical connector may be a board-to-board electrical connector or the like. The first electrical connector is fastened and electrically connected to the connection portion of the flexible printed circuit. The second electrical connector is fastened and electrically connected to the second circuit board. The first electrical connector is fastened and electrically connected to the second electrical connector. The flexible printed circuit is configured to implement an electrical connection between the first component and the second component.

The first circuit board and the second circuit board may be stacked. The bending portion of the flexible printed circuit is bent, so that the circuit board assembly forms a sandwich stack structure. The entire circuit board assembly occupies relatively small space, and requires relatively small installation space. This helps reduce installation difficulty and improve an application scope. In some other implementations, the first circuit board and the second circuit board may alternatively form another relative position relationship, for example, a staggered arrangement.

In some implementations, the circuit board assembly includes the circuit board, the flexible printed circuit, a first component, and a second component. The flexible printed circuit includes a soldering portion, a mounting portion, and a bending portion that connects the soldering portion and the mounting portion. A structure of each of the soldering portion and the bending portion of the flexible printed circuit may use any one of the foregoing structures. The circuit board may be a printed circuit board or a flexible printed circuit. There may be one or more first components, and the first component is fixedly and electrically connected to the circuit board. The soldering portion of the flexible printed circuit is soldered to the circuit board. There may be one or more second components, and the second component is fastened and electrically connected to the mounting portion of the flexible printed circuit. The flexible printed circuit is configured to implement an electrical connection between the first component and the second component.

According to a fourth aspect, this application further provides an electronic device, including a housing and the foregoing circuit board assembly. The circuit board assembly is installed inside the housing.

### BRIEF DESCRIPTION OF DRAWINGS

FIG. 1 is a schematic diagram of a structure of a conventional flexible printed circuit;
FIG. 2 is a schematic diagram of a structure of a cross section of the flexible printed circuit shown in FIG. 1 that is cut along A-A;
FIG. 3 is a schematic diagram of a partial structure of the flexible printed circuit shown in FIG. 1;
FIG. 4 is a schematic diagram of a structure, in some embodiments, of a flexible printed circuit according to an embodiment of this application;
FIG. 5 is a schematic diagram of a structure of a cross section of the flexible printed circuit shown in FIG. 4 that is cut along B-B;
FIG. 6 is a schematic diagram of a partial structure of the flexible printed circuit shown in FIG. 4;
FIG. 7 is a schematic diagram of a partial structure of the trace layer shown in FIG. 5;
FIG. 8 is a schematic diagram of an internal structure, in some other embodiments, of a flexible printed circuit according to an embodiment of this application;
FIG. 9 is a schematic diagram of an internal structure, in some other embodiments, of a flexible printed circuit according to an embodiment of this application;
FIG. 10 is a schematic diagram of a partial structure of the flexible printed circuit shown in FIG. 9;
FIG. 11 is a schematic diagram of an internal structure, in some other embodiments, of a flexible printed circuit according to an embodiment of this application;
FIG. 12 is a schematic diagram of an internal structure, in some other embodiments, of a flexible printed circuit according to an embodiment of this application;
FIG. 13 is a schematic diagram of an internal structure, in some other embodiments, of a flexible printed circuit according to an embodiment of this application;
FIG. 14 is a schematic diagram of an internal structure, in some other embodiments, of a flexible printed circuit according to an embodiment of this application;
FIG. 15 is a schematic diagram of an internal structure, in some other embodiments, of a flexible printed circuit according to an embodiment of this application;
FIG. 16 is a schematic diagram of an internal structure, in some other embodiments, of a flexible printed circuit according to an embodiment of this application;
FIG. 17 is a schematic diagram of a structure, in some other embodiments, of a circuit board assembly according to an embodiment of this application;
FIG. 18 is a schematic diagram of a structure of the circuit board assembly shown in FIG. 17 from another angle;
FIG. 19 is a schematic diagram of a partial structure of the circuit board assembly shown in FIG. 17;
FIG. 20 is a schematic diagram of a structure, in some other embodiments, of a circuit board assembly according to an embodiment of this application;
FIG. 21 is a schematic diagram of a partial structure of the circuit board assembly shown in FIG. 20;
FIG. 22 is a schematic diagram of a structure, in some embodiments, of a circuit board assembly according to an embodiment of this application;
FIG. 23 is a schematic diagram of a structure, in some other embodiments, of a circuit board assembly according to an embodiment of this application; and
FIG. 24 is a schematic diagram of a structure, in some other embodiments, of a circuit board assembly according to an embodiment of this application.

### DESCRIPTION OF EMBODIMENTS

The following describes technical solutions of embodiments in this application with reference to the accompanying drawings. In the descriptions of embodiments of this application, unless otherwise specified, "/" indicates "or". For example, A/B may indicate A or B. The term "and/or" in this specification merely describes an association relationship for describing associated objects, and indicates that three relationships may exist. For example, A and/or B may indicate the following three cases: Only A exists, both A and B exist, and only B exists. In addition, in the descriptions of embodiments of this application, "a plurality of" means two or more, in other words, "a plurality of" means at least two.

In the descriptions of embodiments of this application, it should be noted that terms "installation", "connection", and "disposition" should be understood in a broad sense unless there is a clear stipulation and limitation. For example, "connection" may be a detachable connection, an undetachable connection, a direct connection, or an indirect connection through an intermediate medium.

The terms "first", "second", and the like are only intended for a purpose of description, and should not be understood as an indication or implication of relative importance or implicit indication of a quantity of indicated technical features. Therefore, a feature limited by "first " or "second" may explicitly indicate or implicitly include one or more such features.

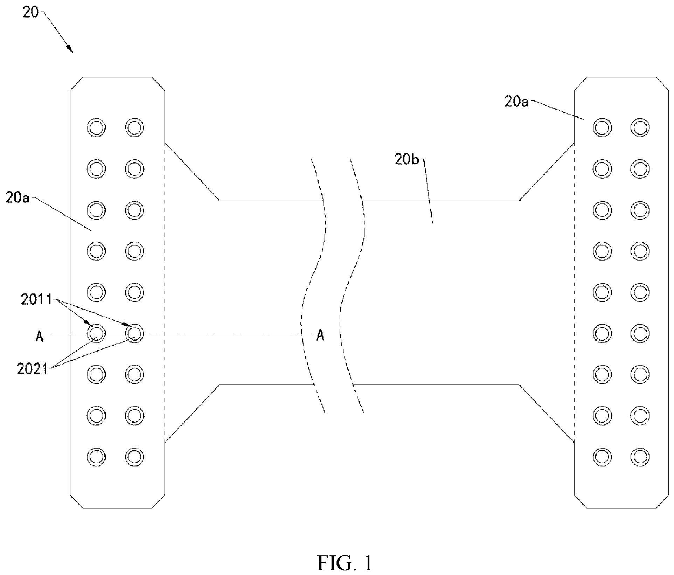

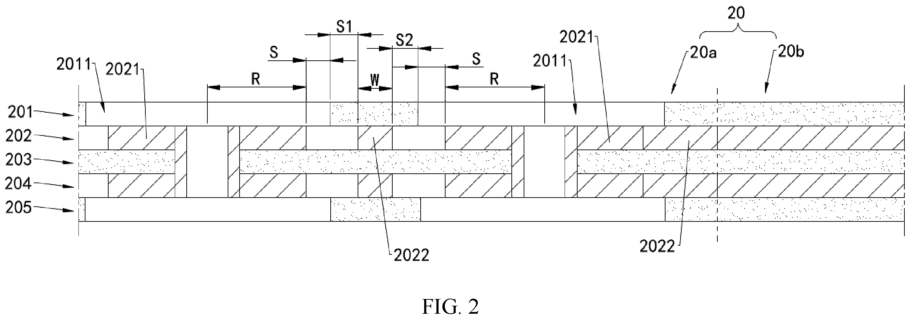

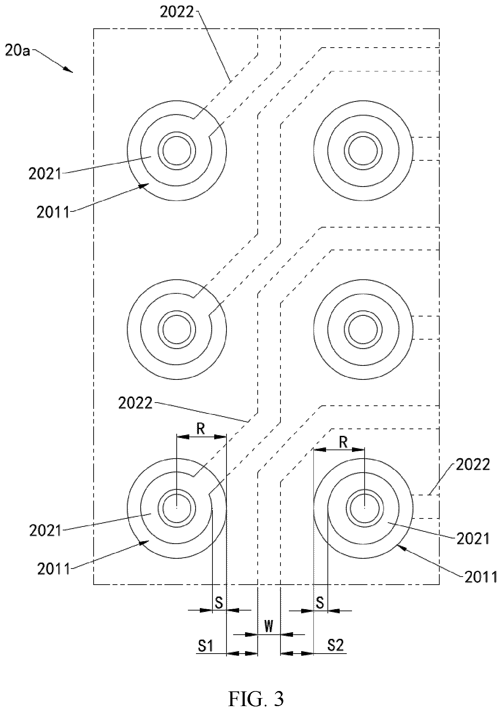

Refer to FIG. 1 to FIG. 3. FIG. 1 is a schematic diagram of a structure of a conventional flexible printed circuit 20 used in a flexible printed circuit on board structure. FIG. 2 is a schematic diagram of a structure of a cross section of the flexible printed circuit 20 shown in FIG. 1 that is cut along A-A. FIG. 3 is a schematic diagram of a partial structure of the flexible printed circuit 20 shown in FIG. 1.

The conventional flexible printed circuit 20 includes two soldering portions 20a and a bending portion 20b that connects the two soldering portions 20a, and the bending portion 20b can change a shape, for example, can be bent. The flexible printed circuit 20 includes a first protective layer 201, a first conductive layer 202, an insulation layer 203, a second conductive layer 204, and a second protective layer 205 that are sequentially stacked. The first protective layer 201 and the second protective layer 205 are also insulation layers, and may also be referred to as solder mask layers. The first protective layer 201 and the second protective layer 205 are two surface layers of the flexible printed circuit 20. The first conductive layer 202 includes a plurality of pads 2021 and a plurality of traces 2022. The first protective layer 201 is provided with a plurality of openings 2011 for exposing the plurality of pads 2021.

One or more traces 2022 are usually arranged between two adjacent pads 2021. When one trace 2022 is arranged between the two adjacent pads 2021, a center spacing between the two adjacent pads 2021 includes: radiuses R of the two pad 2021, two distances S between an edge of the opening 2011 of the first protective layer 201 and the pad 2021, two distances S1 and S2 between the edge of the opening 2011 and the trace 2022, and a width W of the trace 2022, in other words, the center spacing between the two adjacent pads 2021 = 2R + 2S + S1 + S2 + W. In some products, considering a general processing capability for the current flexible printed circuit 20 in the industry, taking minimum values as an example, R is 0.15 mm, S is 0.075 mm, both S1 and S2 are 0.075 mm, and W is 0.1 mm. In this case, a pad spacing is greater than 0.7 mm. Such large pad spacing leads to a large surface size of the soldering portion 20a and a large volume of the flexible printed circuit 20.

This application provides a flexible printed circuit. A soldering layer on which only a pad is arranged and no trace is arranged is added to a soldering portion of the flexible printed circuit, and a solder mask-free design is used, so that a pad spacing of the soldering layer is not limited by structures such as the trace and a solder mask opening. The pad spacing can be obviously reduced, so that a surface area of the soldering portion can be reduced, facilitating miniaturization of the flexible printed circuit. This application further provides a circuit board assembly including the foregoing flexible printed circuit, and an electronic device including the foregoing circuit board assembly.

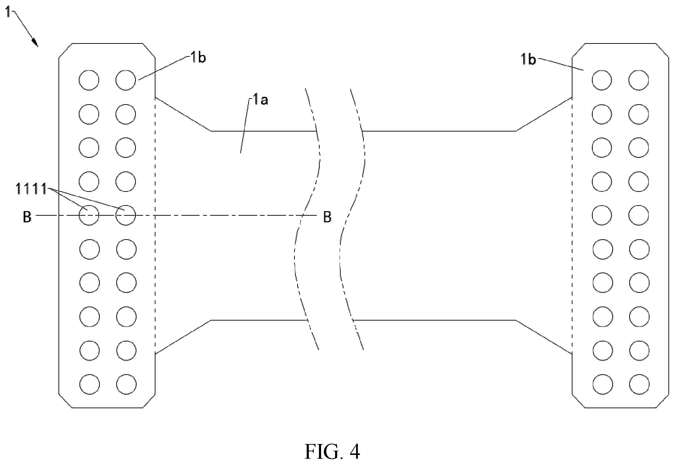

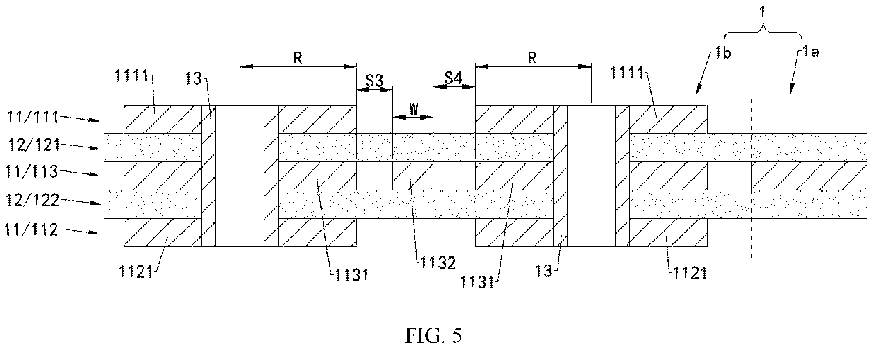

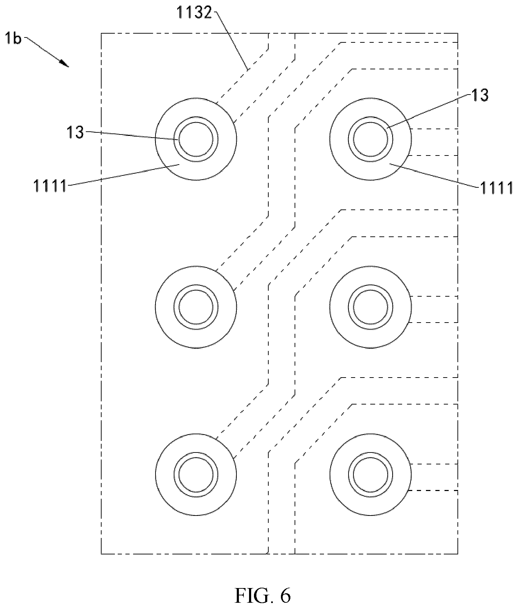

Refer to FIG. 4 to FIG. 6. FIG. 4 is a schematic diagram of a structure, in some embodiments, of a flexible printed circuit 1 according to an embodiment of this application. FIG. 5 is a schematic diagram of a structure of a cross section of the flexible printed circuit 1 shown in FIG. 4 that is cut along B-B. FIG. 6 is a schematic diagram of a partial structure of the flexible printed circuit 1 shown in FIG. 4.

In some embodiments, the flexible printed circuit 1 includes a bending portion 1a and a soldering portion 1b connected to the bending portion 1a. The flexible printed circuit 1 may be an integrally formed mechanical part, and the bending portion 1a and the soldering portion 1b are two parts of the flexible printed circuit 1. The bending portion 1a can change a shape, for example, can be bent, so that the flexible printed circuit 1 can change a shape. The flexible printed circuit 1 may be soldered to another component (for example, a printed circuit board) by using the soldering portion 1b, in other words, the soldering portion 1b is configured to connect to the another component, to implement an electrical connection to the another component. There may be two soldering portions 1b. The two soldering portions 1b may be respectively connected to two ends of the bending portion 1a. The two soldering portions 1b may be respectively soldered to different components. The flexible printed circuit 1 can implement electrical connections between different components.

The flexible printed circuit 1 includes a plurality of conductive layers 11 and a plurality of insulation layers 12. The plurality of conductive layers 11 and the plurality of insulation layers 12 are stacked, and the insulation layer 12 is disposed between two adjacent conductive layers 11. The conductive layer 11 is configured to implement a conducting function, and the conductive layer 11 may be made of a conductive material like copper foil. The insulation layer 12 is configured to implement an insulation function, and the insulation layer 12 may be made of an insulation material like polyimide (Polyimide, PI). The insulation layer 12 can electrically isolate the adjacent conductive layers 11.

It may be understood that a bonding layer (not shown in the figure) may be disposed between the conductive layer 11 and the insulation layer 12 to implement mutual fastening, or no bonding layer may be disposed, and the conductive layer 11 and the insulation layer 12 may directly contact each other and be fastened. A decision of whether disposing a bonding layer between the conductive layer 11 and the adjacent insulation layer 12 may be the same or different. A manner of fastening the plurality of conductive layers 11 and the plurality of insulation layers 12 and a fastening structure are not strictly limited in this embodiment of this application.

For example, the plurality of conductive layers 11 include a first soldering layer 111, a second soldering layer 112, and a trace layer 113.

Both the first soldering layer 111 and the second soldering layer 112 are conductive layers, and the first soldering layer 111 and the second soldering layer 112 are configured to solder another component, to implement an electrical connection between the flexible printed circuit 1 and the another component. Both the first soldering layer 111 and the second soldering layer 112 are located in the soldering portion 1b. The first soldering layer 111 is one surface layer of the soldering portion 1b, and the first soldering layer 111 is formed by a plurality of first pads 1111 that are spaced from each other. In this embodiment of this application, that two structures are spaced from each other means that the two structures are separated by a specific distance, and a gap is formed between the two structures. The plurality of first pads 1111 may be arranged in an array or in another arrangement manner. The second soldering layer 112 is the other surface layer of the soldering portion 1b, and the second soldering layer 112 is formed by a plurality of second pads 1121 that are spaced from each other. The plurality of second pads 1121 may be arranged in an array or in another arrangement manner. In this embodiment of this application, a surface layer of the soldering portion 1b is a layer structure on an outermost side of the soldering portion 1b, and "outer side" of the flexible printed circuit 1 is an orientation close to external space.

The trace layer 113 is a conductive layer, and at least a trace is arranged in the trace layer 113, to implement electrical signal transmission through the trace. An electrical signal may include, but is not limited to, one or more of a power signal, a ground signal, and a data signal. The trace layer 113 is located between the first soldering layer 111 and the second soldering layer 112, and extends from the soldering portion 1b to the bending portion 1a. There may be one or more trace layers 113. When there are a plurality of trace layers 113, the insulation layer is disposed between two adjacent trace layers 113.

The first pad 1111 and the second pad 1121 are connected by using a through hole conductor 13, and the through hole conductor 13 is connected to the trace layer 113. In this case, the first pad 1111 and the second pad 1121 can be electrically connected by using the through hole conductor 13, and may also be electrically connected to the trace layer 113 by using the through hole conductor 13.

For example, a quantity of first pads 1111 and a quantity of second pads 1121 may be the same. The plurality of first pads 1111 and the plurality of second pads 1121 may be disposed in a one-to-one correspondence, and the corresponding first pad 1111 and second pad 1121 are connected by using the through hole conductor 13. The corresponding first pad 1111 and second pad 1121 may be in a same or similar shape and size. The through hole conductor 13 may be a conductive layer structure formed in a through hole wall, or a conductor pillar structure filled in a through hole. This is not strictly limited in this embodiment of this application.

In some other embodiments, the quantity of first pads 1111 and the quantity of second pads 1121 may be different. Some first pads 1111 and some second pads 1121 are correspondingly disposed, or some first pads 1111 and all second pads 1121 are correspondingly disposed, or all first pads 1111 and some second pads 1121 are correspondingly disposed. The corresponding first pad 1111 and second pad 1121 may still be connected by using the through hole conductor 13.

For example, the plurality of insulation layers 12 include a first insulation layer 121 and a second insulation layer 122. The first insulation layer 121 is located between the first soldering layer 111 and the adjacent trace layer 113, and extends from the soldering portion 1b to the bending portion 1a. A part of the first insulation layer 121 located in the soldering portion 1b isolates the first soldering layer 111 from the adjacent trace layer 113. Apart of the first insulation layer 121 located in the bending portion 1a forms one surface layer of the bending portion 1a, and forms a protective layer, configured to protect an internal structure of the bending portion 1a.

The second insulation layer 122 is located between the second soldering layer 112 and the adjacent trace layer 113, and extends from the soldering portion 1b to the bending portion 1a. A part of the second insulation layer 122 located in the soldering portion 1b isolates the second soldering layer 112 from the adjacent trace layer 113. A part of the second insulation layer 122 located in the bending portion 1a forms the other surface layer of the bending portion 1a, and forms a protective layer, configured to protect the internal structure of the bending portion 1a.

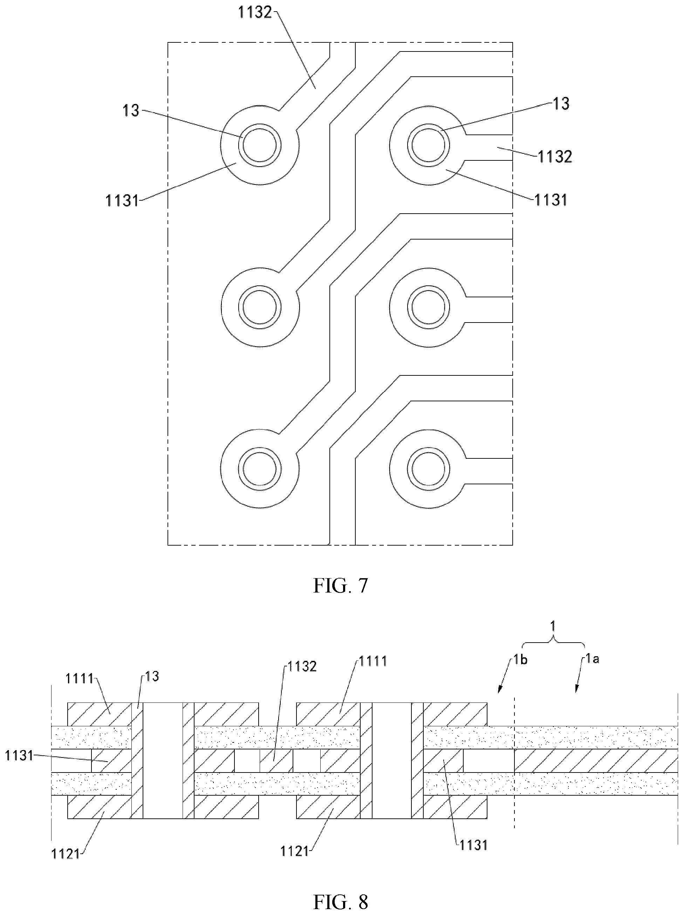

Refer to FIG. 5 to FIG. 7. FIG. 7 is a schematic diagram of a partial structure of the trace layer 113 shown in FIG. 5.

In some embodiments, the trace layer 113 includes a conductor block 1131 and a trace 1132. The conductor block 1131 is located in the soldering portion 1b. One end of the trace 1132 is connected to the conductor block 1131, and the other end extends to the bending portion 1a. The first pad 1111 and the second pad 1121 are connected to the conductor block 1131 by using the through hole conductor 13. The first pad 1111 and the second pad 1121 may be electrically connected to another part or another component of the flexible printed circuit 1 by using the conductor block 1131 and the trace 1132.

In this embodiment, as the first soldering layer 111 and the second soldering layer 112 are used as two surface layers of the soldering portion 1b, only the first pad 1111 is arranged and no trace is arranged on the first soldering layer 111, and only the second pad 1121 is arranged and no trace is arranged on the second soldering layer 112. Therefore, a protective layer (or referred to as a solder mask layer) does not need to be arranged outside the first soldering layer 111 and the second soldering layer 112 in the soldering portion 1b, and no solder mask opening structure needs to be disposed. This can implement a solder mask-free design, and the pad spacing in the soldering portion 1b (that is, a spacing between two adjacent first pads 1111 and a spacing between two adjacent second pads 1121) is not limited by structures such as a trace and a solder mask opening. Compared with a pad spacing in a conventional technology, the pad spacing is obviously reduced, so that a surface area of the soldering portion 1b can be reduced, facilitating miniaturization of the flexible printed circuit 1. In addition, the trace of the flexible printed circuit 1 is arranged on the trace layer 113, is an inner layer structure of the flexible printed circuit 1, and is covered by the insulation layer 12 or the protective layer. This helps improve circuit reliability of the flexible printed circuit 1.

In addition, compared with a conventional product, the flexible printed circuit 1 in this application separately disposes a plurality of pads on the soldering layer. The soldering layer may increase a quantity of conductive layers (for example, one conductive layer is added to the structure in the embodiment shown in FIG. 5 compared with the structure shown in FIG. 2). However, because a thickness of the conductive layer 11 is very small, for example, a thickness of a current copper foil layer is usually 0.25 micrometer, an increase in an overall thickness of the flexible printed circuit 1 in this application is small and controllable, and does not cause obvious adverse impact or an obvious obstacle to miniaturization of both a circuit board assembly and an electronic device that use the flexible printed circuit 1.

Both the conductor block 1131 and the trace 1132 are conductive components. The conductor block 1131 is configured to electrically connect the first pad 1111 and the second pad 1121 by using the through hole conductor 13, and may be further configured to electrically connect an inner conductive structure (for example, the trace 1132) of the flexible printed circuit 1. In this case, the flexible printed circuit 1 can be electrically connected to another component by using the first pad 1111 and the second pad 1121.

In some embodiments, a shape of the conductor block 1131 may be the same as or similar to a shape of the first pad 1111, for example, both are circular. For example, an area of the conductor block 1131 is the same as an area of the first pad 1111. As shown in FIG. 5, a center spacing between the two adjacent first pads 1111 includes: radiuses R of the two first pads 1111, a width W of the trace 1132, two distances S3 and S4 between the first pad 1111 and the trace 1132, in other words, the center spacing between the two adjacent first pads 1111 = 2R + W + S3 + S4. In some products, with a same processing capability, taking minimum values as an example, R is 0.15 mm, S is 0.075 mm, both S3 and S4 are 0.075 mm, and W is 0.1 mm. In this case, the pad spacing in the soldering portion 1b is reduced to 0.55 mm. Compared with the pad spacing in a conventional solution, the pad spacing in this application may be reduced by about 22%. In a structure in which the plurality of pads are arranged in an array, the surface area of the soldering portion 1b of the flexible printed circuit 1 in this application may be about 40% less than a surface area of a soldering portion of a conventional product. The surface area of the soldering portion 1b is greatly reduced, which facilitates miniaturization of the flexible printed circuit 1 and miniaturization of both the circuit board assembly and the electronic device that use the flexible printed circuit 1.

FIG. 8 is a schematic diagram of an internal structure, in some other embodiments, of a flexible printed circuit 1 according to an embodiment of this application. The flexible printed circuit 1 shown in this embodiment may include most of the technical features in the foregoing embodiments. The following mainly describes a difference between the flexible printed circuit 1 in the foregoing embodiments and that in this embodiment, while skipping what is shared in common.

In some embodiments, an area of a conductor block 1131 may be less than an area of a first pad 1111. In this embodiment, because the first pad 1111 and a second pad 1121 are connected to the conductor block 1131 by using a through hole conductor 13, locations of the first pad 1111 and the second pad 1121 are limited by a disposition of the conductor block 1131. The area of the conductor block 1131 is less than the area of the first pad 1111, so that the area of the conductor block 1131 may be set to a small value when an internal connection requirement (that is, the conductor block is connected to the through hole conductor 13) is met. In this way, when a trace layer 113 meets an arrangement requirement of a trace 1132, a spacing between two adjacent conductor blocks 1131 may be relatively small. Then, a center spacing between two adjacent first pads 1111 is relatively small. This can further reduce the pad spacing in the soldering portion 1b, facilitating miniaturization of the flexible printed circuit 1.

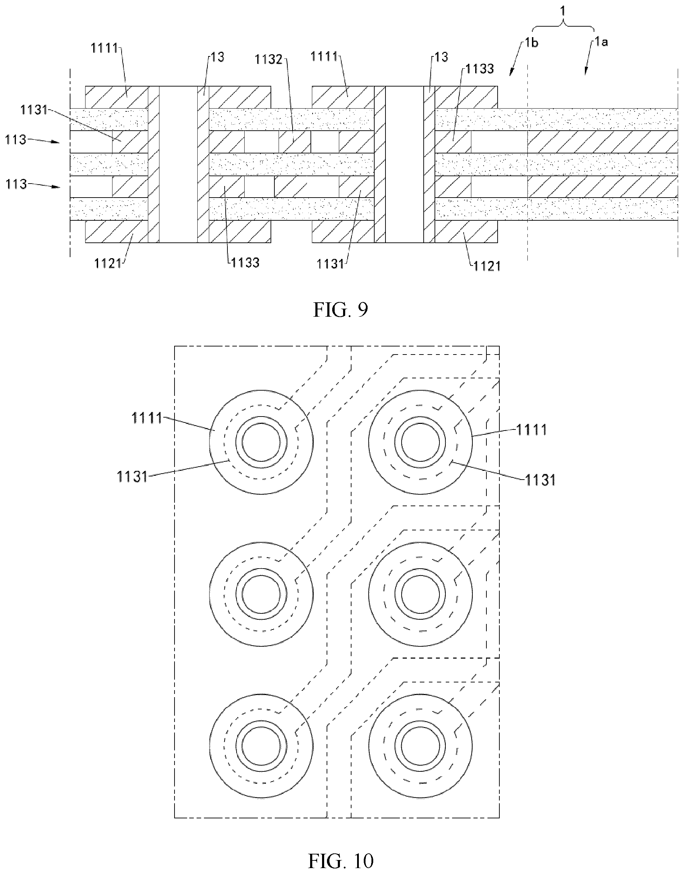

Refer to FIG. 9 and FIG. 10. FIG. 9 is a schematic diagram of an internal structure, in some other embodiments, of a flexible printed circuit 1 according to an embodiment of this application. FIG. 10 is a schematic diagram of a partial structure of the flexible printed circuit 1 shown in FIG. 9. The flexible printed circuit 1 shown in this embodiment may include most of the technical features in the foregoing embodiments. The following mainly describes a difference between the flexible printed circuit 1 in the foregoing embodiments and that in this embodiment, while skipping what is shared in common.

In some embodiments, there may be a plurality of trace layers 113 of the flexible printed circuit 1, for example, two layers, three layers, or four layers. In this embodiment, two layers are used as an example for description and illustration. A plurality of conductor blocks 1131 connected to a plurality of first pads 1111 may be distributed on different trace layers 113. For example, conductor blocks 1131 that are correspondingly connected to at least two first pads 1111 in the plurality of first pads 1111 may be located on different trace layers 113. For example, the plurality of first pads 1111 include a 1^{st} first pad and a 2^{nd} first pad. The 1^{st} first pad is connected to a 1^{st} conductor block and the 1^{st} conductor block is located on a 1^{st} trace layer. The 2^{nd} first pad is connected to a 2^{nd} conductor block, and the 2^{nd} conductor block is located on a 2^{nd} trace layer. The foregoing "1^{st}" and "2^{nd}" are descriptions for distinguishing between two structures, and do not constitute a sequence limitation, an importance limitation, or another limitation.

It may be understood that, the trace layer 113 arranged with the conductor block 1131 further needs to be provided with the trace 1132 connected to the conductor block 1131. Therefore, when the plurality of conductor blocks 1131 connected to the plurality of first pads 1111 are centrally arranged on a specific trace layer 113 of the flexible printed circuit 1, the trace layer 113 has a relatively high trace arrangement requirement. As a result, space of the trace layer 113 is insufficient, and trace arrangement is difficult. When the conductor blocks 1131 correspondingly connected to the at least two first pads 1111 in the plurality of first pads 1111 are located on the different trace layers 113, traces 1132 connected to the conductor blocks 1131 may also be distributed on the different trace layers 113. This reduces routing difficulty of the trace layers 113 and improves routing flexibility.

In some embodiments, a soldering portion 1b of the flexible printed circuit 1 is provided with a plurality of punctured regions, and a plurality of through hole conductors 13 pass through the plurality of punctured regions in a one-to-one correspondence. A first soldering layer 111, a second soldering layer 112, and the trace layer 113 each are provided with a plurality of corresponding punctured regions. The punctured region includes space occupied by the through hole conductor 13, and space in a specific range around the through hole conductor 13. For example, a plurality of first pads 1111 are disposed in a plurality of punctured regions of the first soldering layer 111, and a plurality of through hole conductors 13 pass through the plurality of first pads 1111 and are connected to the first pads 1111. A plurality of second pads 1121 are disposed in a plurality of punctured regions of the second soldering layer 112, and a plurality of through hole conductors 13 pass through the plurality of second pads 1121 and are connected to the second pads 1121.

There may be one or more trace layers 113. Each trace layer 113 is provided with a plurality of punctured regions. Support blocks are disposed in the punctured regions, and a plurality of through hole conductors 13 pass through the plurality of punctured regions in a one-to-one correspondence. The through hole conductors 13 pass through the support blocks and are connected to the support blocks. For example, as shown in FIG. 5, when there is one trace layer 113, and the plurality of conductor blocks 1131 connected to the plurality of first pads 1111 are all located on the trace layer 113, support blocks in punctured regions of the trace layer 113 are the conductor blocks 1131, and the through hole conductor 13 passes through the conductor blocks 1131 and are connected to the conductor blocks 1131. As shown in FIG. 9, when there are a plurality of trace layers 113, and the plurality of conductor blocks 1131 connected to the plurality of first pads 1111 are distributed on different trace layers 113, support blocks in a plurality of punctured regions of the trace layers 113 may be conductor blocks 1131 or bottom pads 1133 (target pads). In other words, when there are the plurality of trace layers 113, if the conductor blocks 1131 are not arranged in the punctured regions of the trace layer 113, the bottom pads 1133 are arranged. Both the bottom pad 1133 and the conductor block 1131 are essentially conductor structures. A difference between the bottom pad 1133 and the conductor block 1131 lies in that the bottom pad 1133 is not connected to the trace, and is a suspended structure in a transmission circuit of the flexible printed circuit 1, and the conductor block 1131 is connected to the trace 1132 and is a part of the transmission circuit. An area of the bottom pad 1133 may be greater than, less than, or equal to an area of the conductor block 1131. This is not strictly limited in this embodiment of this application.

In this embodiment, because the support block (the conductor block 1131 or the bottom pad 1133) is disposed in punctured regions of each trace layer 113 of the flexible printed circuit 1, an overall support structure of each punctured region of the flexible printed circuit 1 is stable, and collapse is unlikely to occur. In addition, thicknesses of the plurality of punctured regions of the flexible printed circuit 1 can be consistent. This facilitates batch punching and metal filling, and improves production efficiency and a yield of the flexible printed circuit 1.

It may be understood that, in the foregoing embodiment, when a quantity of trace layers 113 of the flexible printed circuit 1 is relatively small (for example, one layer, two layers, or three layers), a thickness of the bending portion 1a of the flexible printed circuit 1 is very small, so that bending performance can be ensured, the flexible printed circuit 1 can meet a diversified installation environment, and reliability is better. In some other embodiments, a quantity of trace layers 113 of the flexible printed circuit 1 may alternatively be relatively large, to meet a routing requirement like a plurality of transmission channels.

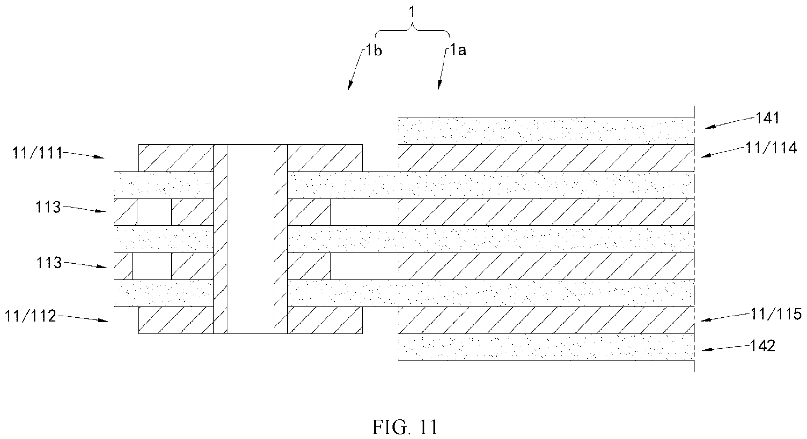

FIG. 11 is a schematic diagram of an internal structure, in some other embodiments, of a flexible printed circuit 1 according to an embodiment of this application. The flexible printed circuit 1 shown in this embodiment may include most of the technical features in the foregoing embodiments. The following mainly describes a difference between the flexible printed circuit 1 in the foregoing embodiments and that in this embodiment, while skipping what is shared in common.

In some embodiments, a plurality of conductive layers 11 further include a first routing layer 114 and a second routing layer 115. Both the first routing layer 114 and the second routing layer 115 are located in a bending portion 1a. The first routing layer 114 and a first soldering layer 111 are disposed on a same layer. The first routing layer 114 is a conductive layer, and at least one or more traces are arranged to implement electrical signal transmission through the traces. The second routing layer 115 and a second soldering layer 112 are disposed on a same layer. The second routing layer 115 is a conductive layer, and at least one or more traces are arranged to implement electrical signal transmission through the traces. The first routing layer 114 and/or the second routing layer 115 may be electrically connected to a trace layer 113.

The flexible printed circuit 1 further includes a first protective layer 141 and a second protective layer 142. Both the first protective layer 141 and the second protective layer 142 are located in a bending portion 1a. The first protective layer 141 is located on a side that is of the first routing layer 114 and that is away from the trace layer 113. The second protective layer 142 is located on a side that is of the second routing layer 115 and that is away from the trace layer 113. The first protective layer 141 and the second protective layer 142 are two surface layers of the bending portion 1a. Both the first protective layer 141 and the second protective layer 142 are insulation layers, and are configured to protect an internal structure of the flexible printed circuit 1. The first protective layer 141 and the second protective layer 142 may also be referred to as solder mask layers.

In this embodiment, the first routing layer 114 and the second routing layer 115 are disposed in the bending portion 1a of the flexible printed circuit 1. The first routing layer 114, the second routing layer 115, and the trace layer 113 may all be configured for trace arrangement. Therefore, the flexible printed circuit 1 can better meet a routing requirement like a plurality of transmission channels.

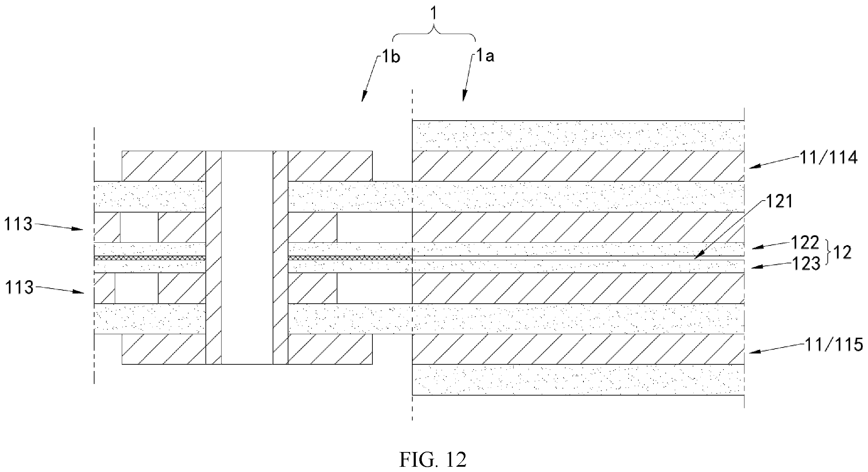

FIG. 12 is a schematic diagram of an internal structure, in some other embodiments, of a flexible printed circuit 1 according to an embodiment of this application. The flexible printed circuit 1 shown in this embodiment may include most of the technical features in the foregoing embodiment. The following mainly describes a difference between the flexible printed circuit 1 in the foregoing embodiments and that in this embodiment, while skipping what is shared in common.

In some embodiments, when there are two or more conductive layers 11 of the flexible printed circuit 1, at least one insulation layer 12 of the flexible printed circuit 1 may form an air gap (Air gap) in a bending portion 1a. In other words, the bending portion 1a of the flexible printed circuit 1 forms one or more air gaps. In this way, structures of the flexible printed circuit 1 located on two sides of the air gap may move relatively independently, to improve bending performance of the bending portion 1a of the flexible printed circuit 1.

For example, the flexible printed circuit 1 may be of a four-layer board structure. A plurality of conductive layers 11 of the flexible printed circuit 1 may include a first routing layer 114, a second routing layer 115, and two trace layers 113. The insulation layer 12 located between the two trace layers 113 may form the air gap 121 in the bending portion 1a. The insulation layer 12 located between the two trace layers 113 may include a first insulation sub-layer 122 and a second insulation sub-layer 123. A part of the first insulation sub-layer 122 in a soldering portion 1b and a part of the second insulation sub-layer 123 in the soldering portion 1b may be press-fitted and fastened by using adhesive on both the first insulation sub-layer 122 and the second insulation sub-layer 123. Adhesive on both a part of the first insulation sub-layer 122 in the bending portion 1a and a part of the second insulation sub-layer 123 in the bending portion 1a may be removed or omitted. An air gap 121 is formed between the part of the first insulation sub-layer 122 in the bending portion 1a and the part of the second insulation sub-layer 123 in the bending portion 1a.

In some other embodiments, when a plurality of conductive layers 11 of the flexible printed circuit 1 do not include a first routing layer 114 and a second routing layer 115, but include a plurality of trace layers 113, one or more air gaps may also be formed in the bending portion 1a, so that bending performance of the bending portion 1a of the flexible printed circuit 1 is better.

It may be understood that when there are two or more conductive layers 11 of the flexible printed circuit 1, a stack structure of the flexible printed circuit 1 may be implemented in a plurality of manners. For example, when there are three conductive layers 11, the bending portion 1a may form a single-layer + double-layer stack structure by using one air gap, or form a single-layer + single-layer + single-layer stack structure by using two air gaps. When there are four conductive layers 11, the bending portion 1a may form a double-layer + double-layer stack structure by using one air gap, or form a single-layer + double-layer + single-layer stack structure by using two air gaps, or form a single-layer + single-layer + single-layer + single-layer stack structure by using three air gaps. The quantity of conductive layers 11 of the flexible printed circuit 1 and a specific stack structure are not strictly limited in this embodiment of this application.

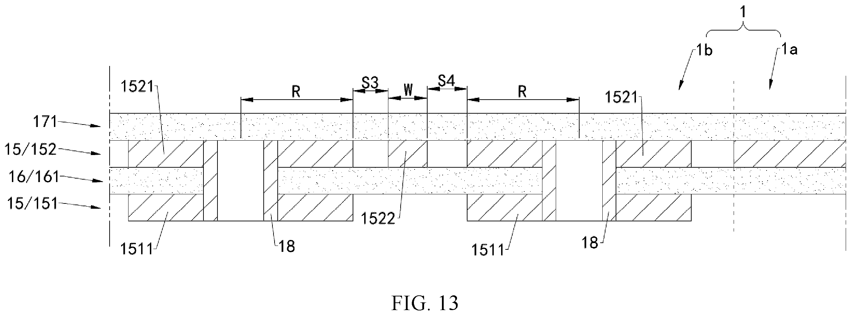

FIG. 13 is a schematic diagram of an internal structure, in some other embodiments, of a flexible printed circuit 1 according to an embodiment of this application.

In some embodiments, the flexible printed circuit 1 includes a bending portion 1a and a soldering portion 1b connected to the bending portion 1a. The flexible printed circuit 1 may be an integrally formed mechanical part, and the bending portion 1a and the soldering portion 1b are two parts of the flexible printed circuit 1. The bending portion 1a can change a shape, for example, can be bent, so that the flexible printed circuit 1 can change a shape. The flexible printed circuit 1 may be soldered to another component (for example, a printed circuit board) by using the soldering portion 1b, in other words, the soldering portion 1b is configured to connect to the another component, to implement an electrical connection to the another component. There may be two soldering portions 1b. The two soldering portions 1b may be respectively connected to two ends of the bending portion 1a. The two soldering portions 1b may be respectively soldered to different components. The flexible printed circuit 1 can implement electrical connections between different components.

In the foregoing embodiment, surface layers on both sides of the soldering portion 1b of the flexible printed circuit 1 form soldering structures. In this embodiment, a surface layer on a side of the soldering portion 1b of the flexible printed circuit 1 forms a soldering structure, and a surface layer on the other side does not form a soldering structure. Specifically:

The flexible printed circuit 1 includes a plurality of conductive layers 15, a plurality of insulation layers 16, and a first protective layer 171. The plurality of conductive layers 15, the plurality of insulation layers 16, and the first protective layer 171 are stacked, and the insulation layer 16 is disposed between two adjacent conductive layers 15. The conductive layer 15 is configured to implement a conducting function, and the conductive layer 15 may be made of a conductive material like copper foil. The insulation layer 16 is configured to implement an insulation function, and the insulation layer 16 may be made of an insulation material like polyimide (Polyimide, PI). The insulation layer 16 can electrically isolate the adjacent conductive layers 15.

It may be understood that a bonding layer (not shown in the figure) may be disposed between the conductive layer 15 and the insulation layer 16 to implement mutual fastening, or no bonding layer may be disposed, and the conductive layer 15 and the insulation layer 16 may directly contact each other and be fastened. A decision of whether disposing a bonding layer between the conductive layer 15 and the adjacent insulation layer 16 may be the same or different. A manner of fastening the plurality of conductive layers 15 and the plurality of insulation layers 16 and a fastening structure are not strictly limited in this embodiment of this application.

For example, the plurality of conductive layers 15 include a soldering layer 151 and a trace layer 152.

The soldering layer 151 is a conductive layer, and the soldering layer 151 is configured to solder another component, to implement an electrical connection between the flexible printed circuit 1 and the another component. The soldering layer 151 is located in the soldering portion 1b, and the soldering layer 151 is one surface layer of the soldering portion 1b. The soldering layer 151 is formed by a plurality of pads 1511 that are spaced from each other. The plurality of pads 1511 may be arranged in an array or in another arrangement manner.

The trace layer 152 is a conductive layer, and at least a trace is arranged in the trace layer 152, to implement electrical signal transmission through the trace. An electrical signal may include, but is not limited to, one or more of a power signal, a ground signal, and a data signal. The trace layer 152 is located on a side of the soldering layer 151, and extends from the soldering portion 1b to the bending portion 1a. There may be one or more trace layers 152. When there are a plurality of trace layers 152, the insulation layer is disposed between two adjacent trace layers 152. The pad 1511 is connected to the trace layer 152 by using a through hole conductor 18. The through hole conductor 18 may be a conductive layer structure formed on a through hole wall, or a conductor pillar structure filled in a through hole. This is not strictly limited in this embodiment of this application.

The trace layer 152 may include a conductor block 1521 and a trace 1522. The conductor block 1521 is located in the soldering portion 1b. One end of the trace 1522 is connected to the conductor block 1521, and the other end extends to the bending portion 1a. The pad 1511 of the soldering layer 151 is connected to the conductor block 1521 by using the through hole conductor 18, and the pad 1511 may be electrically connected to another part or another component of the flexible printed circuit 1 by using the conductor block 1521 and the trace 1522.

The first protective layer 171 is located on a side that is of the trace layer 152 and that is away from the soldering layer 151. The first protective layer 171 extends from the soldering portion 1b to the bending portion 1a. Apart of the first protective layer 171 located in the soldering portion 1b forms the other surface layer of the soldering portion 1b. A part of the first protective layer 171 located in the bending portion 1a forms one surface layer of the bending portion 1a. The first protective layer 171 is also an insulation layer, and may also be referred to as a solder mask layer, and is configured to protect an internal structure of the flexible printed circuit 1. The soldering portion 1b is not provided with a soldering structure on a side of the first protective layer 171. The soldering portion 1b does not need to dispose structures such as a trace and a solder mask opening on the first protective layer 171. The first protective layer 171 may be a continuous and complete surface structure.

The plurality of insulation layers 16 may include a first insulation layer 161. The first insulation layer 161 is located between the soldering layer 151 and the adjacent trace layer 152, and extends from the soldering portion 1b to the bending portion 1a. Apart of the first insulation layer 161 located in the bending portion 1a forms the other surface layer of the bending portion 1a. A part that is of the first insulation layer 161 located in the soldering portion 1b is configured to isolate the soldering layer 151 from the trace layer 152.

In this embodiment, the soldering layer 151 is used as one surface layer of the soldering portion 1b, and only the pad 1511 is arranged and no trace is arranged on the soldering layer 151. Therefore, the soldering portion 1b does not need to arrange a protective layer (or referred to as a solder mask layer) outside the soldering layer 151, and no solder mask opening structure needs to be disposed. This can implement a solder mask-free design, and the pad spacing in the soldering portion 1b is not limited by structures such as a trace and a solder mask opening. Compared with a pad spacing in a conventional technology, the pad spacing is obviously reduced, so that a surface area of the soldering portion 1b can be reduced, facilitating miniaturization of the flexible printed circuit 1.

In addition, compared with a conventional product, the flexible printed circuit 1 in this application separately disposes a plurality of pads on the soldering layer. The soldering layer may increase a quantity of conductive layers. However, because a thickness of the conductive layer is very small, for example, a thickness of a current copper foil layer is usually 0.25 micrometer, an increase in an overall thickness of the flexible printed circuit 1 in this application is small and controllable, and does not cause obvious adverse impact or an obvious obstacle to miniaturization of both a circuit board assembly and an electronic device that use the flexible printed circuit 1.

In some embodiments, a shape of the conductor block 1521 may be the same as or similar to a shape of the pad 1511, for example, both are circular. For example, an area of the conductor block 1521 is the same as an area of the pad 1511. As shown in FIG. 13, a center spacing between the two adjacent pads 1511 includes: radiuses R of the two pads 1511, a width W of the trace, two distances S3 and S4 between the pad 1511 and the trace, in other words, the center spacing between the two adjacent pads 1511 = 2R + W + S3 + S4. In some products, a same processing capability and minimum values are used as an example. R is 0.15 mm, S is 0.075 mm, both S3 and S4 are 0.075 mm, and W is 0.1 mm. In this case, the pad spacing is reduced to 0.55 mm. Compared with the pad spacing in a conventional solution, the pad spacing in this application may be reduced by about 22%. In a structure in which the plurality of pads 1511 are arranged in an array, the surface area of the soldering portion 1b of the flexible printed circuit 1 in this application may be about 40% less than a surface area of a soldering portion of a conventional product. The surface area of the soldering portion 1b is greatly reduced, which facilitates miniaturization of the flexible printed circuit 1 and miniaturization of both the circuit board assembly and the electronic device that use the flexible printed circuit 1.

In some other embodiments, an area of the conductor block 1521 may be less than an area of the pad 1511. In this embodiment, because the pad 1511 is connected to the conductor block 1521 by using the through hole conductor 18, a location of the pad 1511 is limited by a disposition of the conductor block 1521. The area of the conductor block 1521 is less than the area of the pad 1511, so that the area of the conductor block 1521 may be set to a small value when an internal connection requirement (that is, the conductor block 1521 is connected to the through hole conductor 18) is met. In this way, when the trace layer 152 meets a trace arrangement, a spacing between two adjacent conductor blocks 1521 may be relatively small. Then, a center spacing between two adjacent pads 1511 is relatively small. This can further reduce the pad spacing in the soldering portion 1b, facilitating miniaturization of the flexible printed circuit 1.

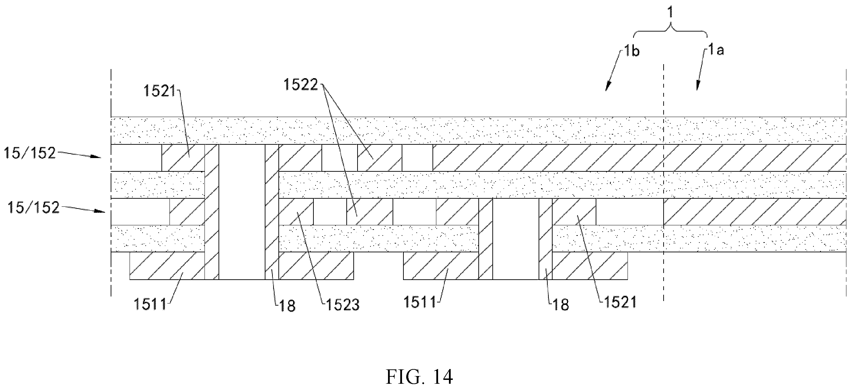

FIG. 14 is a schematic diagram of an internal structure, in some other embodiments, of a flexible printed circuit 1 according to an embodiment of this application. The flexible printed circuit 1 shown in this embodiment may include most of the technical features in the foregoing embodiments. The following mainly describes a difference between the flexible printed circuit 1 in the foregoing embodiments and that in this embodiment, while skipping what is shared in common.

In some embodiments, there may be a plurality of trace layers 152 of the flexible printed circuit 1, for example, two layers, three layers, or four layers. In this embodiment, two layers are used as an example for description and illustration. Two conductor blocks 1521 that are correspondingly connected to two adjacent pads 1511 may be located on different trace layers 152. A plurality of conductor blocks 1521 connected to a plurality of pads 1511 may be distributed on different trace layers 152. For example, conductor blocks 1521 that are correspondingly connected to at least two pads 1511 in the plurality of pads 1511 may be located on different trace layers 152. For example, the plurality of pads 1511 include a 1^{st} pad and a 2^{nd} pad. The 1^{st} pad is connected to a 1^{st} conductor block and the 1^{st} conductor block is located on a 1^{st} trace layer. The 2^{nd} pad is connected to a 2^{nd} conductor block, and the 2^{nd} conductor block is located on a 2^{nd} trace layer. The foregoing "1^{st}" and "2^{nd}" are descriptions for distinguishing between two structures, and do not constitute a sequence limitation, an importance limitation, or another limitation.

It may be understood that, the trace layer 152 arranged with the conductor block 1521 further needs to arrange the trace 1522 connected to the conductor block 1521. Therefore, when the plurality of conductor blocks 1521 connected to the plurality of pads 1511 are centrally arranged on a specific trace layer 152 of the flexible printed circuit 1, the trace layer 152 has a relatively high trace arrangement requirement. As a result, space of the trace layer 152 is insufficient, and trace arrangement is difficult. When the conductor blocks 1521 correspondingly connected to the at least two pads 1511 in the plurality of pads 1511 are located on the different trace layers 152, traces 1522 connected to the conductor blocks 1521 may also be distributed on the different trace layers 152. This reduces routing difficulty of the trace layers 152 and improves routing flexibility.

In some embodiments, a soldering portion 1b of the flexible printed circuit 1 is provided with a plurality of punctured regions, and a plurality of through hole conductors 18 pass through the plurality of punctured regions in a one-to-one correspondence. The soldering layer 151 and the trace layer 152 each are provided with a plurality of corresponding punctured regions. The punctured region includes space occupied by the through hole conductor 18, and space in a specific range around the through hole conductor 18. For example, a plurality of pads 1511 are disposed in a plurality of punctured regions of the soldering layer 151, and a plurality of through hole conductors 18 pass through the plurality of pads 1511 and are connected to the pads 1511.

There may be one or more trace layers 152. Each trace layer 152 is provided with a plurality of punctured regions. Support blocks are disposed in the punctured regions, and a plurality of through hole conductors 18 pass through the plurality of punctured region in a one-to-one correspondence. The through hole conductors 18 pass through the support blocks and are connected to the support blocks. For example, as shown in FIG. 13, when there is one trace layer 152, and the plurality of conductor blocks 1521 connected to the plurality of pads 1511 are all located on the trace layer 152, support blocks in punctured regions of the trace layer 152 are the conductor blocks 1521, and the through hole conductor 18 passes through the conductor blocks 1521 and are connected to the conductor blocks 1521. As shown in FIG. 14, when there are a plurality of trace layers 152, and the plurality of conductor blocks 1521 connected to the plurality of pads 1511 are distributed on different trace layers 152, support blocks in a plurality of punctured regions of the trace layers 152 may be conductor blocks 1521 or bottom pads 1523 (target pads). In other words, when there are the plurality of trace layers 152, if the conductor blocks 1521 are not arranged in the punctured regions of the trace layer 152, the bottom pads 1523 are arranged. Both the bottom pad 1523 and the conductor block 1521 are essentially conductor structures. A difference between the bottom pad 1523 and the conductor block 1521 lies in that the bottom pad 1523 is not connected to the trace, and is a suspended structure in a transmission circuit of the flexible printed circuit 1, and the conductor block 1521 is connected to the trace 1522 and is a part of the transmission circuit. An area of the bottom pad 1523 may be greater than, less than, or equal to an area of the conductor block 1521. This is not strictly limited in this embodiment of this application.

In this embodiment, because the support block (the conductor block 1521 or the bottom pad 1523) is disposed in punctured regions of each trace layer 152 of the flexible printed circuit 1, an overall support structure of each punctured region of the flexible printed circuit 1 is stable, and collapse is unlikely to occur. In addition, thicknesses of the plurality of punctured regions of the flexible printed circuit 1 can be consistent. This facilitates batch punching and metal filling, and improves production efficiency and a yield of the flexible printed circuit 1.

It may be understood that, when there are the plurality of trace layers 152, some of the plurality of through hole conductors 18 may not pass through all the trace layers 152, but pass through some trace layers 152. For example, as shown in FIG. 14, there are two trace layers 152, some through hole conductors 18 pass through the two trace layers 152, and some through hole conductors 18 pass through one trace layer 152. In this case, quantities of punctured regions of different trace layers 152 may be different, and therefore quantities of support blocks arranged in the punctured regions may be different. The through hole conductors 18 do not pass through all trace layers 152. Trace layers 152 that are not passed through by the through hole conductors 18 may include support regions. The support regions are disposed corresponding to punctured regions of other trace layers 152 that are passed through by the through hole conductors 18. Support blocks may also be disposed in the support area, to improve support strength of the flexible printed circuit 1 corresponding to the through hole conductors 18.

It may be understood that, in the foregoing embodiment, when a quantity of trace layers 152 of the flexible printed circuit 1 is relatively small (for example, one layer, two layers, or three layers), a thickness of the bending portion 1a of the flexible printed circuit 1 is very small, so that bending performance can be ensured, the flexible printed circuit 1 can meet a diversified installation environment, and reliability is better. In some other embodiments, a quantity of trace layers 152 of the flexible printed circuit 1 may alternatively be relatively large, to meet a routing requirement like a plurality of transmission channels.

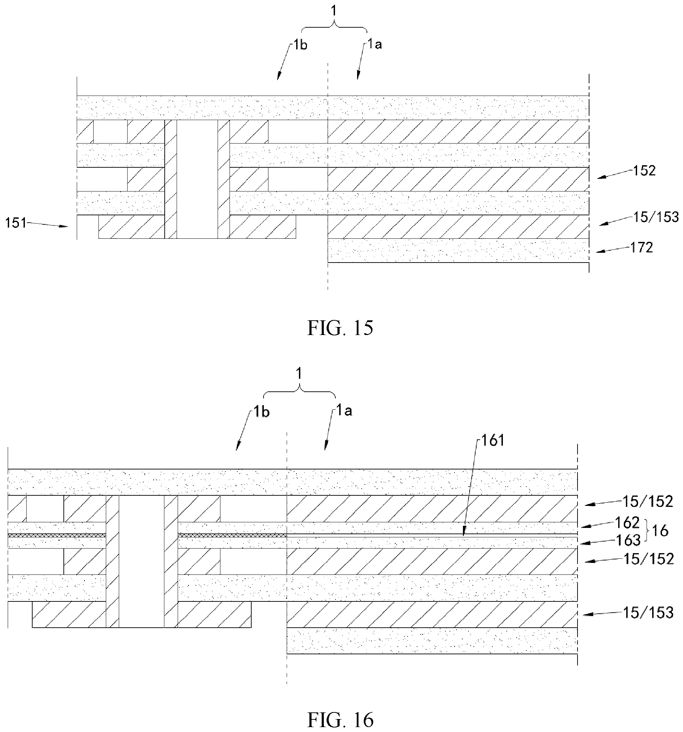

FIG. 15 is a schematic diagram of an internal structure, in some other embodiments, of a flexible printed circuit 1 according to an embodiment of this application. The flexible printed circuit 1 shown in this embodiment may include most of the technical features in the foregoing embodiments. The following mainly describes a difference between the flexible printed circuit 1 in the foregoing embodiments and that in this embodiment, while skipping what is shared in common.

In some embodiments, a plurality of conductive layers 15 further include a routing layer 153, the routing layer 153 is located in a bending portion 1a, and the routing layer 153 and a soldering layer 151 are disposed on a same layer. The routing layer 153 is a conductive layer, and at least one or more traces are arranged to implement electrical signal transmission through the traces. The routing layer 153 is made of a conductive material like copper foil. The routing layer 153 may be electrically connected to a trace layer 152.

The flexible printed circuit 1 further includes a second protective layer 172. The second protective layer 172 is located on a side that is of the routing layer 153 and that is away from the trace layer 152. The second protective layer 172 is located in the bending portion 1a, and is the other surface layer of the bending portion 1a. The second protective layer 172 is an insulation layer, configured to protect an internal structure of the flexible printed circuit 1, and may also be referred to as a solder mask layer.

In this embodiment, the routing layer 153 is disposed in the bending portion 1a of the flexible printed circuit 1. The routing layer 153 and the trace layer 152 may both be configured for trace arrangement. Therefore, the flexible printed circuit 1 can better meet a routing requirement like a plurality of transmission channels.

FIG. 16 is a schematic diagram of an internal structure, in some other embodiments, of a flexible printed circuit 1 according to an embodiment of this application. The flexible printed circuit 1 shown in this embodiment may include most of the technical features in the foregoing embodiments. The following mainly describes a difference between the flexible printed circuit 1 in the foregoing embodiments and that in this embodiment, while skipping what is shared in common.

In some embodiments, when there are two or more conductive layers 15 of the flexible printed circuit 1, at least one insulation layer 16 of the flexible printed circuit 1 may form an air gap (Air gap) in a bending portion 1a. In other words, the bending portion 1a of the flexible printed circuit 1 forms one or more air gaps. In this way, structures of the flexible printed circuit 1 located on two sides of the air gap may move relatively independently, to improve bending performance of the bending portion 1a of the flexible printed circuit 1.

For example, the flexible printed circuit 1 may be of a three-layer board structure. A plurality of conductive layers 15 of the flexible printed circuit 1 may include a routing layer 153 and two trace layers 152. The insulation layer 16 located between the two trace layers 152 may form the air gap 161 in the bending portion 1a. The insulation layer 16 located between the two trace layers 152 may include a first insulation sub-layer 162 and a second insulation sub-layer 163. A part of the first insulation sub-layer 162 in a soldering portion 1b and a part of the second insulation sub-layer 163 in the soldering portion 1b may be press-fitted and fastened by using adhesive on both the first insulation sub-layer 162 and the second insulation sub-layer 163. Adhesive on both a part of the first insulation sub-layer 162 in the bending portion 1a and a part of the second insulation sub-layer 163 in the bending portion 1a may be removed or omitted. An air gap 161 is formed between the part of the first insulation sub-layer 162 in the bending portion 1a and the part of the second insulation sub-layer 163 in the bending portion 1a. The air gap may also be formed between the routing layer 153 and the trace layer 152.

In some other embodiments, when a plurality of conductive layers 15 of the flexible printed circuit 1 does not include a routing layer 153, but includes a plurality of trace layers 152. One or more air gaps may also be formed in the bending portion 1a, so that bending performance of the bending portion 1a of the flexible printed circuit 1 is better.

It may be understood that when there are two or more conductive layers 15 of the flexible printed circuit 1, a stack structure of the flexible printed circuit 1 may be implemented in a plurality of manners. For example, when there are three conductive layers 15, the bending portion 1a may form a single-layer + double-layer stack structure by using one air gap, or form a single-layer + single-layer + single-layer stack structure by using two air gaps. When there are four conductive layers 15, the bending portion 1a may form a double-layer + double-layer stack structure by using one air gap, or form a single-layer + double-layer + single-layer stack structure by using two air gaps, or form a single-layer + single-layer + single-layer stack structure by using three air gaps. The quantity of conductive layers 15 of the flexible printed circuit 1 and a specific stack structure are not strictly limited in this embodiment of this application.

In some other embodiments, the flexible printed circuit 1 may also include two routing layers 153, for example, include a first routing layer and a second routing layer. Both the first routing layer and the second routing layer are located in the bending portion 1a. The first routing layer and a soldering layer 151 are disposed on a same layer. The second routing layer is located on a side that is of a first protective layer 171 and that is away from the trace layer 152. In this case, the flexible printed circuit 1 may further include a second protective layer and a third protective layer. Both the second protective layer and the third protective layer are located in the bending portion 1a. The second protective layer is located on a side that is of the first routing layer and that is away from the trace layer 152. The third protective layer is located on a side that is of the second routing layer and that is away from the trace layer 152. In this embodiment, a part of the first protective layer 171 located in the bending portion 1a is no longer a surface layer of the bending portion 1a, but is an internal layer structure of the bending portion 1a.

In the foregoing plurality of embodiments, the flexible printed circuit 1 may include the two soldering portions 1b and the bending portion 1a. The bending portion 1a is connected between the two soldering portions 1b. The two soldering portions 1b are soldered to different components. The flexible printed circuit 1 implements electrical connections between the different components.

In some other embodiments, the flexible printed circuit 1 may alternatively include a soldering portion 1b and a bending portion 1a, and may further include a connection portion. The bending portion 1a may be connected between the soldering portion 1b and the connection portion. The connection portion may be configured to fasten an electrical connector. The electrical connector includes but is not limited to a board-to-board (board to board, BTB) connector and the like. When the soldering portion 1b and the electrical connector are connected to different components, the flexible printed circuit 1 can implement electrical connections between the different components. Designs of the soldering portion 1b and the bending portion 1a of the flexible printed circuit 1 may be the same as or similar to those in the foregoing plurality of embodiments, and details are not described herein again.

In some other embodiments, the flexible printed circuit 1 may alternatively include a soldering portion 1b, a bending portion 1a, and a mounting portion. The bending portion 1a may be connected between the soldering portion 1b and the mounting portion. The mounting portion may be configured to mount a component. The component may be a chip and/or an auxiliary component of the chip. When the soldering portion 1b of the flexible printed circuit 1 is fastened and electrically connected to another component, the component mounted on the mounting portion of the flexible printed circuit 1 is electrically connected to a corresponding component. When the mounting portion of the flexible printed circuit 1 mounts the component, the flexible printed circuit 1 and the component jointly form an assembly of the flexible printed circuit 1 (Flexible Printed Circuit Assembly, FPCA). Designs of the soldering portion 1b and the bending portion 1a of the flexible printed circuit 1 may be the same as or similar to those in the foregoing plurality of embodiments, and details are not described herein again.

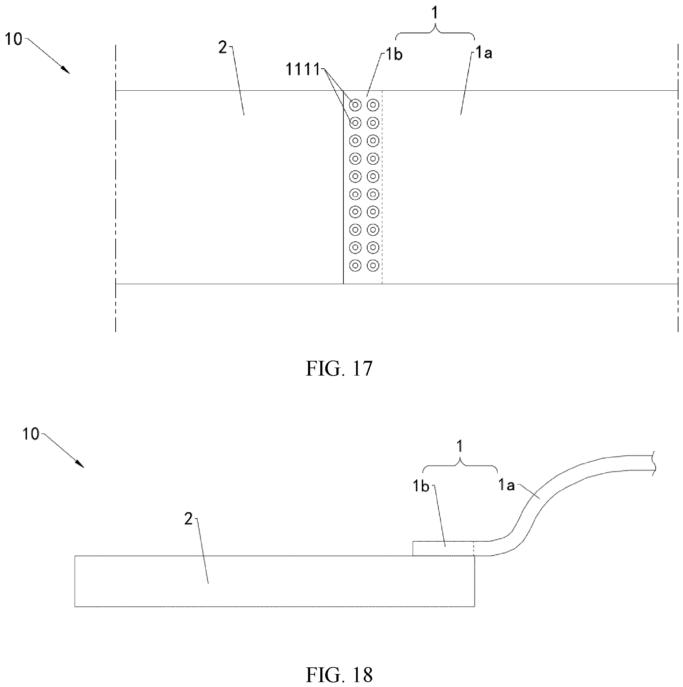

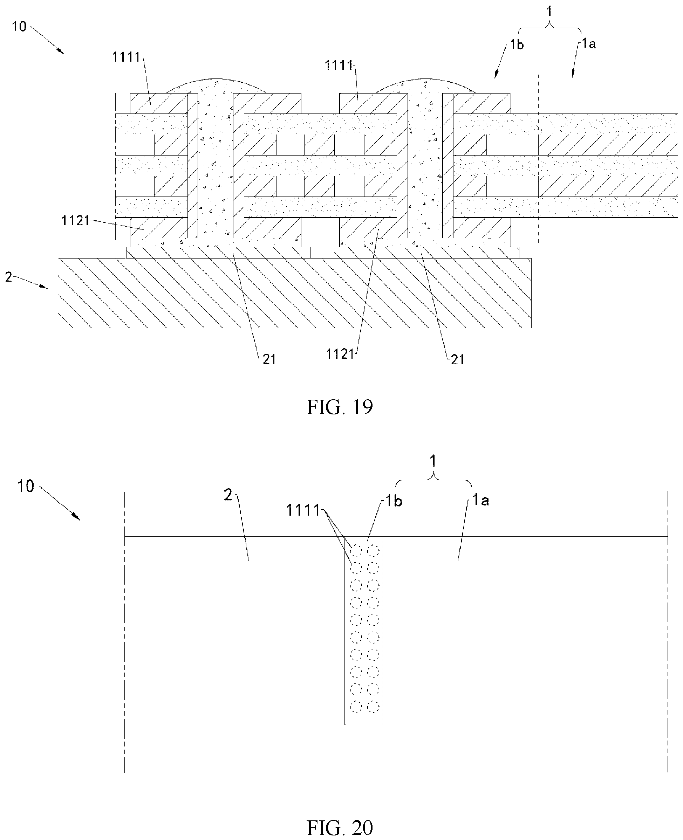

Refer to FIG. 17 to FIG. 19. FIG. 17 is a schematic diagram of a structure, in some embodiments, of a circuit board assembly 10 according to an embodiment of this application. FIG. 18 is a schematic diagram of a structure of the circuit board assembly 10 shown in FIG. 17 from another angle. FIG. 19 is a schematic diagram of a partial structure of the circuit board assembly 10 shown in FIG. 17.

In some embodiments, the circuit board assembly 10 includes a circuit board 2 and a flexible printed circuit 1. A soldering portion 1b of the flexible printed circuit 1 is soldered to the circuit board 2, and a bending portion 1a may change a shape based on an installation environment. The circuit board 2 may be a printed circuit board or a flexible printed circuit. A plurality of pads 21 are disposed on the circuit board 2. The plurality of pads 21 of the circuit board 2 correspond to pad structures (namely, a first pad 1111 and a second pad 1121) of the soldering portion 1b of the flexible printed circuit 1.

The soldering portion 1b may be fastened and electrically connected to the circuit board 2 by using a surface mount technology (Surface mount technology, SMT), a hotbar soldering (Hotbar) technology, or another manner. It may be understood that, FIG. 19 uses a structure of the flexible printed circuit 1 shown in FIG. 9 as an example. The flexible printed circuit 1 of the circuit board assembly 10 in this embodiment may alternatively use a structure of another flexible printed circuit in which both surface layers of the soldering portion 1b include soldering structures in the foregoing embodiments, for example, a structure shown in FIG. 5, FIG. 8, FIG. 11, or FIG. 12.

When the soldering portion 1b of the flexible printed circuit 1 is fastened to the circuit board 2 through hot pressing soldering, solder paste and solder flux may be pre-disposed on the pads (namely, the first pad 1111 and the second pad 1121) of the soldering portion 1b and the pad 21 of the circuit board 2. Then, soldering is implemented between the pads by heating by using a pulse heat head, to implement electrical conduction between the flexible printed circuit 1 and the circuit board 2. When the soldering portion 1b of the flexible printed circuit 1 is fastened to the circuit board 2 by using the surface mount technology, the flexible printed circuit 1 may be soldered to the circuit board 2 as a component, or the circuit board 2 may be soldered to the flexible printed circuit 1 as a component, to implement electrical conduction between the flexible printed circuit 1 and the circuit board 2.

In this embodiment, because the pads (namely, the first pad 1111 and the second pad 1121) of the soldering portion 1b of the flexible printed circuit 1 are structures protruding from a surface, solder paste collapse and a short circuit can be avoided in a soldering process, and a soldering joint is ensured to have a specific height. This improves soldering quality and reliability.

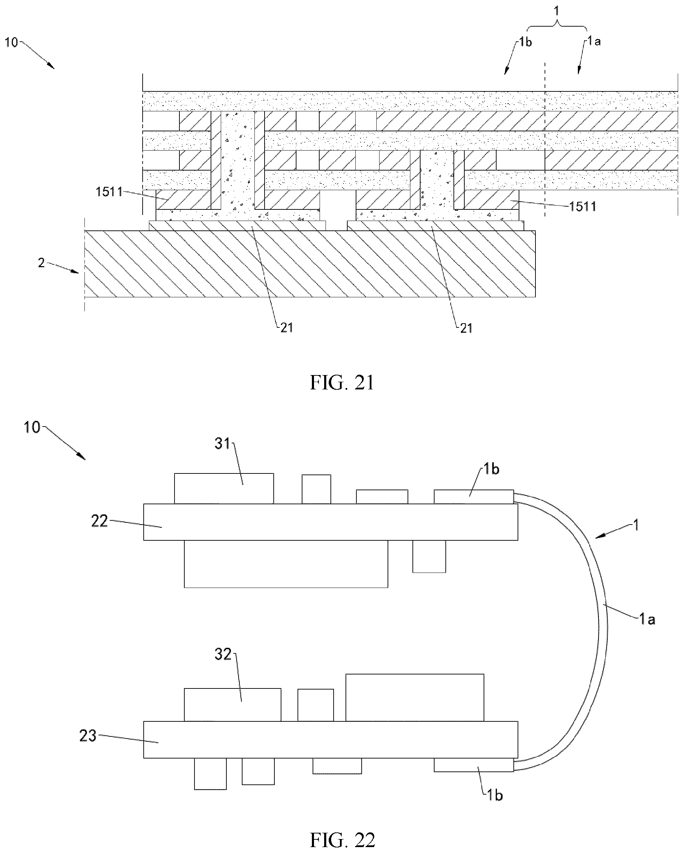

Refer to FIG. 20 and FIG. 21. FIG. 20 is a schematic diagram of a structure, in some other embodiments, of a circuit board assembly 10 according to an embodiment of this application. FIG. 21 is a schematic diagram of a partial structure of the circuit board assembly 10 shown in FIG. 20.

In some embodiments, the circuit board assembly 10 includes a circuit board 2 and a flexible printed circuit 1. A soldering portion 1b of the flexible printed circuit 1 is soldered to the circuit board 2, and a bending portion 1a may change a shape based on an installation environment. The circuit board 2 may be a printed circuit board or a flexible printed circuit. A plurality of pads 21 are disposed on the circuit board 2. The plurality of pads 21 of the circuit board 2 correspond to a structure of a pad 1511 of the soldering portion 1b of the flexible printed circuit 1.

The soldering portion 1b may be fastened and electrically connected to the circuit board 2 by using a surface mount technology (Surface mount technology, SMT) or in another manner. It may be understood that, FIG. 21 uses a structure of the flexible printed circuit 1 shown in FIG. 14 as an example. The flexible printed circuit 1 of the circuit board assembly 10 in this embodiment may alternatively use a structure of another flexible printed circuit in which one surface layer of the soldering portion 1b includes a soldering structure and the other surface layer does not include a soldering structure in the foregoing embodiments, for example, a structure shown in FIG. 13, FIG. 15, or FIG. 16.

When the soldering portion 1b of the flexible printed circuit 1 is fastened to the circuit board 2 by using the surface mount technology, the flexible printed circuit 1 may be soldered to the circuit board 2 as a component, or the circuit board 2 may be soldered to the flexible printed circuit 1 as a component, to implement electrical conduction between the flexible printed circuit 1 and the circuit board 2.

In some embodiments, in the circuit board assembly 10 shown in FIG. 17 to FIG. 21, the circuit board assembly 10 may further include one or more components, and the one or more components may be soldered to the circuit board 2 and/or soldered to the flexible printed circuit 1. When the circuit board 2 is a printed circuit board, and a component is mounted on the circuit board 2, the circuit board 2 and the component may jointly form a printed circuit board assembly (Printed Circuit Board Assembly, PCBA).

In some embodiments, in the circuit board assembly 10 shown in FIG. 17 to FIG. 21, the circuit board assembly 10 may further include an electrical connector. The electrical connector may be fastened and electrically connected to the flexible printed circuit 1, so that the flexible printed circuit 1 may be electrically connected to another component by using the electrical connector.

The following describes some embodiments of the circuit board assembly 10.

FIG. 22 is a schematic diagram of a structure, in some embodiments, of a circuit board assembly 10 according to an embodiment of this application.

In some embodiments, the circuit board assembly 10 includes a first circuit board 22, a second circuit board 23, a flexible printed circuit 1, a first component 31, and a second component 32. The flexible printed circuit 1 includes two soldering portions 1b and a bending portion 1a that connects the two soldering portions 1b. The two soldering portions 1b of the flexible printed circuit 1 are respectively soldered to the first circuit board 22 and the second circuit board 23. For a structure of each of the soldering portion 1b and the bending portion 1a of the flexible printed circuit 1, refer to any structure in the foregoing embodiments. The first circuit board 22 may be a printed circuit board or a flexible printed circuit, and the second circuit board 23 may be a printed circuit board or a flexible printed circuit. There may be one or more first components 31, and the first component 31 is fastened and electrically connected to the first circuit board 22. There may be one or more second components 32, and the second component 32 is fastened and electrically connected to the second circuit board 23. The flexible printed circuit 1 is configured to implement an electrical connection between the first component 31 and the second component 32.

The first circuit board 22 and the second circuit board 23 may be stacked. The bending portion 1a of the flexible printed circuit 1 is bent, so that the circuit board assembly 10 forms a sandwich stack structure. The entire circuit board assembly 10 occupies relatively small space, and requires relatively small installation space. This helps reduce installation difficulty and improve an application scope. In some other embodiments, the first circuit board 22 and the second circuit board 23 may alternatively form another relative position relationship, for example, a staggered arrangement.

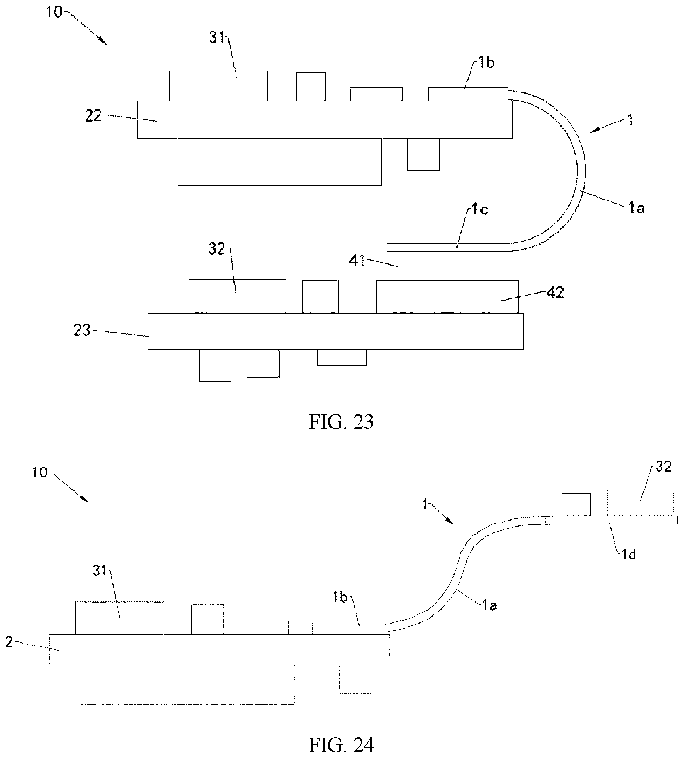

FIG. 23 is a schematic diagram of a structure, in some other embodiments, of a circuit board assembly 10 according to an embodiment of this application.

In some embodiments, the circuit board assembly 10 includes a first circuit board 22, a second circuit board 23, a flexible printed circuit 1, a first electrical connector 41, a second electrical connector 42, a first component 31, and a second component 32. The flexible printed circuit 1 includes a soldering portion 1b, a connecting portion 1c, and a bending portion 1a that connects the soldering portion 1b and the connecting portion 1c. For a structure of each of the soldering portion 1b and the bending portion 1a of the flexible printed circuit 1, refer to any structure in the foregoing embodiments. The first circuit board 22 may be a printed circuit board or a flexible printed circuit. There may be one or more first components 31, and the first component 31 is fastened and electrically connected to the first circuit board 22. The soldering portion 1b of the flexible printed circuit 1 is soldered to the first circuit board 22. There may be one or more second components 32, and the second component 32 is fastened and electrically connected to the second circuit board 23. The first electrical connector 41 and the second electrical connector 42 may be a male connector and a female connector respectively, and the male connector and the female connector are paired with each other. Each of the first electrical connector 41 and the second electrical connector 42 may be a board-to-board electrical connector or the like. The first electrical connector 41 is fastened and electrically connected to the connection portion 1c of the flexible printed circuit 1. The second electrical connector 42 is fastened and electrically connected to the second circuit board 23. The first electrical connector 41 is fastened and electrically connected to the second electrical connector 42. The flexible printed circuit 1 is configured to implement an electrical connection between the first component 31 and the second component 32.

The first circuit board 22 and the second circuit board 23 may be stacked. The bending portion 1a of the flexible printed circuit 1 is bent, so that the circuit board assembly 10 forms a sandwich stack structure. The entire circuit board assembly 10 occupies relatively small space, and requires relatively small installation space. This helps reduce installation difficulty and improve an application scope. In some other embodiments, the first circuit board 22 and the second circuit board 23 may alternatively form another relative position relationship, for example, a staggered arrangement.

FIG. 24 is a schematic diagram of a structure, in some other embodiments, of a circuit board assembly 10 according to an embodiment of this application.

In some embodiments, the circuit board assembly 10 includes a circuit board 2, a flexible printed circuit 1, a first component 31, and a second component 32. The flexible printed circuit 1 includes a soldering portion 1b, a mounting portion 1d, and a bending portion 1a that connects the soldering portion 1b and the mounting portion 1d. For a structure of each of the soldering portion 1b and the bending portion 1a of the flexible printed circuit 1, refer to any structure in the foregoing embodiments. The circuit board 2 may be a printed circuit board or a flexible printed circuit. There may be one or more first components 31, and the first component 31 is fastened and electrically connected to the circuit board 2. The soldering portion 1b of the flexible printed circuit 1 is soldered to the circuit board 2. There may be one or more second components 32, and the second component 32 is fastened and electrically connected to the mounting portion 1d of the flexible printed circuit 1. The flexible printed circuit 1 is configured to implement an electrical connection between the first component 31 and the second component 32.

An embodiment of this application further provides an electronic device, including a housing and a circuit board assembly. The circuit board assembly may use any structure in the foregoing embodiments, and the circuit board assembly is installed inside the housing. The electronic device may be, but is not limited to, an electronic product like a mobile phone, a tablet computer (pad), a portable game console, a palmtop computer (personal digital assistant, PDA), a notebook computer, an ultra-mobile personal computer (ultra-mobile personal computer, UMPC), a handheld computer, a netbook, a vehicle-mounted media play device, a wearable electronic device, a virtual reality (virtual reality, VR) terminal device, or an augmented reality (augmented reality, AR) terminal device.

For example, when the electronic device is a mobile phone or a tablet computer, and the circuit board assembly uses a structure of the circuit board assembly 10 shown in FIG. 22 or FIG. 23, a first circuit board 22 and a second circuit board 23 may be respectively a primary board and a secondary board, a first component 31 may include a processor and the like, and a second component 32 may include a radio frequency chip and the like.

For example, when the electronic device is a wearable electronic device, for example, a smartwatch or a smart band, and the circuit board assembly uses a structure of the circuit board assembly 10 shown in FIG. 23, a first circuit board 22 may be a circuit board of a heart rate module, a first component 31 may include a heart rate detection sensor, a second circuit board 23 may be a primary board, and a second component 32 may include a processor and the like.

For example, when the electronic device is a Bluetooth headset, and the circuit board assembly 10 uses a structure of the circuit board assembly 10 shown in FIG. 24, a circuit board 2 may be a primary board, a first component 31 may include a processor and the like, and a second component 32 may include a microphone (Microphone, MIC) and/or an auxiliary component thereof.

It may be understood that structures of the circuit board assembly are diversified, and applications of the circuit board assembly in electronic devices of different forms, different types, and different sizes are also diversified. This is not strictly limited in this embodiment of this application.

The foregoing embodiments are only intended for describing the technical solutions of this application, but not for limiting this application. Although this application is described in detail with reference to the foregoing embodiments, persons of ordinary skill in the art should understand that they may still make modifications to the technical solutions described in the foregoing embodiments or make equivalent replacements to some technical features thereof, without departing from the scope of the technical solutions of embodiments of this application.

## Claims

1. A flexible printed circuit, comprising a bending portion and a soldering portion connected to the bending portion, wherein
the flexible printed circuit comprises a plurality of conductive layers and a plurality of insulation layers, and the insulation layer is disposed between two adjacent conductive layers;
the plurality of conductive layers comprise a first soldering layer, a second soldering layer, and a trace layer;
both the first soldering layer and the second soldering layer are located in the soldering portion, the first soldering layer is one surface layer of the soldering portion, the first soldering layer is formed by a plurality of first pads that are spaced from each other, the second soldering layer is the other surface layer of the soldering portion, and the second soldering layer is formed by a plurality of second pads that are spaced from each other; and
the trace layer is located between the first soldering layer and the second soldering layer, and extends from the soldering portion to the bending portion, the first pad and the second pad are connected by using a through hole conductor, and the through hole conductor is connected to the trace layer.

2. The flexible printed circuit according to claim 1, wherein the trace layer comprises a conductor block and a trace, the conductor block is located in the soldering portion, one end of the trace is connected to the conductor block, the other end of the trace extends to the bending portion, and the first pad and the second pad are connected to the conductor block by using the through hole conductor.

3. The flexible printed circuit according to claim 2, wherein an area of the conductor block is less than an area of the first pad.

4. The flexible printed circuit according to claim 2 or 3, wherein there are a plurality of trace layers, and a plurality of conductor blocks connected to the plurality of first pads are located on different trace layers.

5. The flexible printed circuit according to claim 2 or 3, wherein there are one or more trace layers, a plurality of punctured regions are provided on each trace layer, and a plurality of through hole conductors pass through the plurality of punctured regions of each trace layer in a one-to-one correspondence;
support blocks are disposed in the plurality of punctured regions of each trace layer, and the through hole conductors pass through the support blocks and are connected to the support blocks; and
when there is one trace layer, the support block is the conductor block; or when there are a plurality of trace layers, the support block is the conductor block or a bottom pad.

6. The flexible printed circuit according to any one of claims 1 to 5, wherein the plurality of insulation layers comprises a first insulation layer and a second insulation layer;
the first insulation layer is located between the first soldering layer and the adjacent trace layer, and extends from the soldering portion to the bending portion, and a part of the first insulation layer located in the bending portion forms one surface layer of the bending portion; and
the second insulation layer is located between the second soldering layer and the adjacent trace layer, and extends from the soldering portion to the bending portion, and a part of the second insulation layer located in the bending portion forms the other surface layer of the bending portion.

7. The flexible printed circuit according to any one of claims 1 to 5, wherein the plurality of conductive layers further comprise a first routing layer and a second routing layer, both the first routing layer and the second routing layer are located in the bending portion, the first routing layer and the first soldering layer are disposed on a same layer, and the second routing layer and the second soldering layer are disposed on a same layer; and
the flexible printed circuit further comprises a first protective layer and a second protective layer, both the first protective layer and the second protective layer are located in the bending portion, the first protective layer is located on a side that is of the first routing layer and that is away from the trace layer, the second protective layer is located on a side that is of the second routing layer and that is away from the trace layer, and the first protective layer and the second protective layer are two surface layers of the bending portion.

8. The flexible printed circuit according to claim 7, wherein at least one insulation layer of the flexible printed circuit forms an air gap in the bending portion.

9. A flexible printed circuit, comprising a bending portion and a soldering portion connected to the bending portion, wherein
the flexible printed circuit comprises a plurality of conductive layers, a plurality of insulation layers, and a first protective layer, and the insulation layer is disposed between two adjacent conductive layers;
the plurality of conductive layers comprise a soldering layer and a trace layer, the soldering layer is located in the soldering portion, the soldering layer is one surface layer of the soldering portion, the soldering layer is formed by a plurality of pads that are spaced from each other, the trace layer is located on a side of the soldering layer and extends from the soldering portion to the bending portion, and the pad is connected to the trace layer by using a through hole conductor; and
the first protective layer is located on a side that is of the trace layer and that is away from the soldering layer, the first protective layer extends from the soldering portion to the bending portion, a part of the first protective layer located in the soldering portion forms the other surface layer of the soldering portion, and a part of the first protective layer located in the bending portion forms one surface layer of the bending portion.

10. The flexible printed circuit according to claim 9, wherein the trace layer comprises a conductor block and a trace, the conductor block is located in the soldering portion, one end of the trace is connected to the conductor block, the other end of the trace extends to the bending portion, and the pad is connected to the conductor block by using the through hole conductor.

11. The flexible printed circuit according to claim 10, wherein an area of the conductor block is less than an area of the pad.

12. The flexible printed circuit according to claim 10 or 11, wherein there are a plurality of trace layers, and a plurality of conductor blocks connected to the plurality of pads are located on different trace layers.

13. The flexible printed circuit according to claim 10 or 11, wherein there are one or more trace layers, a plurality of punctured regions are provided on each trace layer, and a plurality of through hole conductors pass through the plurality of punctured regions of each trace layer in a one-to-one correspondence;
support blocks are disposed in the plurality of punctured regions of each trace layer, and the through hole conductors pass through the support blocks and are connected to the support blocks; and
when there is one trace layer, the support block is the conductor block; or when there are a plurality of trace layers, the support block is the conductor block or a bottom pad.

14. The flexible printed circuit according to any one of claims 9 to 13, wherein the plurality of insulation layers comprise a first insulation layer, the first insulation layer is located between the soldering layer and the adjacent trace layer, and extends from the soldering portion to the bending portion, and a part of the first insulation layer located in the bending portion forms the other surface layer of the bending portion.

15. The flexible printed circuit according to any one of claims 9 to 13, wherein the plurality of conductive layers further comprise a routing layer, the routing layer is located in the bending portion, and the routing layer and the soldering layer are disposed on a same layer; and
the flexible printed circuit further comprises a second protective layer, the second protective layer is located on a side that is of the routing layer and that is away from the trace layer, and the second protective layer is located in the bending portion and is the other surface layer of the bending portion.

16. The flexible printed circuit according to claim 15, wherein at least one insulation layer of the flexible printed circuit forms an air gap in the bending portion.

17. A circuit board assembly, comprising a circuit board and the flexible printed circuit according to any one of claims 1 to 16, wherein a soldering portion of the flexible printed circuit is soldered to the circuit board.

18. An electronic device, comprising a housing and the circuit board assembly according to claim 17, wherein the circuit board assembly is installed inside the housing.
